# EUROPÄISCHE PATENTSCHRIFT

(11) **EP 2 729 506 B1**
(45) Veröffentlichungstag und Bekanntmachung des Hinweises auf die Patenterteilung: **10.08.2016**
(21) Anmeldenummer: 12743102.1
(22) Anmeldetag: 09.07.2012
(51) Int. Cl.: C08F 12/08, C08G 79/00, C07F 1/08, C08J 3/24, H01L 51/00, C09K 11/66, H05B 33/14

(54) **VERFAHREN ZUR KOVALENTEN BINDUNG EINES ORGANISCHEN METALLKOMPLEXES AN EIN POLYMER**
METHOD FOR COVALENT BINDING OF A METAL COMPOUND TO A POLYMER
PROCÉDÉ DE CONNEXION COVALENTE D'UN COMPLEXE MÉTALLIQUE SUR UN POLYMÈRE

(30) Priorität: 08.07.2011 EP 11173374; 22.07.2011 EP 11175125
(43) Veröffentlichungstag der Anmeldung: 14.05.2014
(73) Patentinhaber: cynora GmbH, 76646 Bruchsal (DE)
(72) Erfinder: VOLZ, Daniel, 76137 Karlsruhe (DE); GRAB, Tobias, 76133 Karlsruhe (DE); BAUMANN, Thomas, 76133 Karlsruhe (DE); BÄCHLE, Michael, 76133 Karlsruhe (DE)
(74) Vertreter: Hoppe, Georg Johannes
(86) Internationale Anmeldenummer: PCT/EP2012/063447
(87) Internationale Veröffentlichungsnummer: WO 2013/007710

(56) Entgegenhaltungen:
- EP-A1- 0 190 998
- EP-A2- 0 050 358
- WO-A1-03/072584
- WO-A1-2005/042550
- WO-A1-2010/082924
- WO-A1-2010/149748
- WO-A1-2011/067401
- DE-A1- 3 337 100
- DE-T2- 69 021 559
- US-A1- 2004 247 934
- US-A1- 2006 269 779
- N. HOLTEN-ANDERSEN ET AL: "pH-induced metal-ligand cross-links inspired by mussel yield self-healing polymer networks with near-covalent elastic moduli", PROCEEDINGS OF THE NATIONAL ACADEMY OF SCIENCES, Bd. 108, Nr. 7, 15. Februar 2011 (2011-02-15), Seiten 2651-2655, XP055015324, ISSN: 0027-8424, DOI: 10.1073/pnas.1015862108
- GARCIA ARMADA M P ET AL: "Electrochemical and bioelectrocatalytical properties of novel block-copolymers containing interacting ferrocenyl units", JOURNAL OF ORGANOMETALLIC CHEMISTRY, ELSEVIER-SEQUOIA S.A. LAUSANNE, CH, Bd. 693, Nr. 16, 1. August 2008 (2008-08-01), Seiten 2803-2811, XP022854180, ISSN: 0022-328X, DOI: 10.1016/J.JORGANCHEM.2008.05.038 [gefunden am 2008-06-04]
- Riedl/Janiak: "Anorganische Chemie", 2007, 7. AUFL, WALTER DE GRUYTER, XP002666355, Seite 306, das ganze Dokument
- BIWU MA ET AL: "Multifunctional crosslinkable iridium complexes as hole transporting/electron blocking and emitting materials for solution-processed multilayer organic light-emitting diodes", ADVANCED FUNCTIONAL MATERIALS, WILEY - V C H VERLAG GMBH & CO. KGAA, DE, Bd. 19, Nr. 7, 9. April 2009 (2009-04-09), Seiten 1024-1031, XP001521551, ISSN: 1616-301X, DOI: 10.1002/ADFM.200801071
- DANIEL VOLZ ET AL: "Auto-catalysed crosslinking for next-generation OLED-design", JOURNAL OF MATERIALS CHEMISTRY, Bd. 22, Nr. 38, 1. Januar 2012 (2012-01-01), Seite 20786, XP55038634, ISSN: 0959-9428, DOI: 10.1039/c2jm33291d
- MEYERS A ET AL: "Design and Synthesis of Alq3-Functionalized Polymers", MACROMOLECULES, AMERICAN CHEMICAL SOCIETY, WASHINGTON, DC; US, Bd. 36, Nr. 6, 25. März 2003 (2003-03-25), Seiten 1766-1768, XP002287215, ISSN: 0024-9297, DOI: 10.1021/MA0259012

## Beschreibung

Die Erfindung betrifft ein Verfahren zur kovalenten Bindung eines organischen Metallkomplexes an ein Polymer (eine polymere Matrix). Der organische Metallkomplex weist mindestens ein Metallzentrum und mindestens einen organischen Liganden auf. Das Verfahren umfasst die Durchführung einer ersten Reaktion, die einen ersten Reaktanden in Form eines organischen Metallkomplexes und einen zweiten Reaktanden in Form eines Polymers aufweist, wobei während der Reaktion der Metallkomplex kovalent an das Polymer gebunden wird.

### Einleitung

Phosphoreszierende Übergangsmetallkomplexe gewinnen aufgrund ihrer Eigenschaften als hocheffiziente Emitter in optoelektronischen Bauteilen wie OLEDs zunehmend stärker an Bedeutung. Die vom Übergangsmetallatom (Schwermetallatom) induzierte Spin-Bahn-Kopplung resultiert in einer erhöhten Intersystem-Crossing-Rate vom angeregten Singulett- zum Triplett-Zustand und somit zu einer Nutzung sowohl der Singulett- als auch der Triplett-Exzitonen für die Emission und ermöglicht dadurch eine theoretisch erreichbare innere Quantenausbeute von 100 %.

Diese phosphoreszierenden Farbstoffe werden üblicherweise in entsprechende energetisch angepasste Hostmaterialien eingebracht. Aufgrund der leichteren Verarbeitbarkeit durch flüssige Prozessierung aus der Lösung eignen sich hierfür insbesondere polymere Strukturen. Diese sollten im Idealfall weitere Aufgaben wie eine räumliche Trennung der Farbstoffmoleküle zur Vermeidung unerwünschter Konzentrations-Quenchprozesse und Triplett-Triplett-Annihilierung unter Emissionsminderung, verbesserte Ladungsträgerinjektion und -transport und eine erhöhte Rekombinationswahrscheinlicheit direkt auf den Emittermolekülen übernehmen.

Demnach stellt die Kombination geeigneter polymerer Hoststrukturen mit entsprechenden statistisch eingemischten Emitterverbindungen und zusätzlich eingebrachten Ladungstransportmolekülen eine vielfältig angewandete Methode zur Herstellung polymerer lichtemittierender Dioden (PLEDs) dar. Obwohl die auf diese Art dargestellten OLED-Bauteile meist hohe Effizienzen aufweisen, können diese Mischsysteme jedoch unerwünschten Phasenseparierungen, Aggregierungen oder Kristallisationsprozessen unterliegen, die sich nachteilig auf die Leistungsfähigkeit und Lebensdauer der Bauteile auswirken. Somit ist die Herstellung angepasster (Co)polymere, die unterschiedliche Funktionen wie Ladungstransport und Emission übernehmen, bei gleichzeitiger Nutzung der Vorteile der flüssigen Verarbeitung von stetig zunehmendem Interesse.

Zur Synthese phosphoreszierender Polymere mit direkt angebundenen Übergangsmetallkomplexen ist im Stand der Technik die nachträgliche Anbindung der Metallkomplexe an die vorher dargestellten, mit funktionellen Gruppen versehenen Polymere ("Komplexierung am Polymer") bekannt. Es ist wünschenswert, derartige Anbindungsreaktionen zu optimieren.

Die Erfindung betrifft ein Verfahren zur Anbindung eines organischen Metallkomplexes an ein Polymer durch Ausbildung kovalenter Bindungen. Kovalent bedeutet hierbei eine Bindung zwischen Nichtmetall-Elementen (C, H, N, S, P, O, Si). Der organische Metallkomplex weist mindestens ein Metallzentrum und mindestens einen organischen Liganden auf, wobei die Bindung des Metallkomplexes an die Matrix über den mindestens einen Liganden erfolgt.

Das Verfahren umfasst das Durchführen einer ersten Reaktion, die einen ersten Reaktanden in Form eines organischen Metallkomplexes und einen zweiten Reaktanden in Form eines Polymers aufweist. Während der ersten Reaktion wird der Metallkomplex über mindestens einen Liganden kovalent an das Polymer gebunden. Diese erste Reaktion wird erfindungsgemäß durch den an das Polymer gebundenen Metallkomplex katalysiert. Der Metallkomplex ist zugleich Edukt/Reaktand und Katalysator.

Das Metallzentrum des Metallkomplexes stellt somit das katalysierende Agens der Reaktion dar. Demgemäß kann das Metallzentrum Re, Fe, Ru, Os, Co, Rh, Ir, Ni, Pd, Pt, Cu, Ag, Au, Zn, Cd, Hg, Sn und/oder Pb sein, und zwar in atomarer oder ionischer Form, also als kationisches Zentralion des Metallkomplexes. Bevorzugter Weise ist das Metallzentrum Cu. Wenn die erste Reaktion als Kreuzkupplungsreaktion wie beispielsweise Suzuki-, Stille- Negishi-, Kumada-, Hiyama-, und Sonogashira-Reaktion durchgeführt wird, ist das Metallzentrum bevorzugt Pd, Pt, oder Ni.

Während dieser ersten Reaktion wird der Metallkomplex über mindestens einen Liganden kovalent an das Polymer gebunden, wobei diese Bindung *einseitig* oder mindestens *zweiseitig* sein kann, d. h. es kann eine Anbindung des Metallkomplexes über nur einen Liganden kovalent an nur ein Polymermolekül oder es kann eine gleichzeitige Anbindung des Metallkomplexes über mindestens zwei Liganden kovalent an mindestens zwei verschiedene Polymermoleküle erfolgen, so dass es zu einer Querverknüpfung des Metallkomplexes im Polymer kommt, wodurch sich ein mehrdimensionales Netzwerk bildet.

Sofern in einer Ausführungsform des Verfahrens ein mehrdimensionales Netzwerk gebildet wird (Querverknüpfung), kann dies in seiner einfachsten Ausprägung eine leiterähnliche (zweidimensionale) Struktur sein, bei der zwei Polymermoleküle durch mindestens einen Metallkomplex verknüpft sind, der über mindestens zwei Liganden mit je einem der Polymermoleküle mindestens eine kovalente Bindung ausbildet. Weiterhin sind komplizierte dreidimensionale Netzwerke als Produkt der ersten Reaktion möglich, die mittels einer variablen Zahl von Polymermolekülen querverknüpfte Metallkomplexe umfassen. Der querverknüpfte Metallkomplex ist somit im mehrdimensionalen Netzwerk immobilisiert.

Zur kovalenten Verknüpfung des organischen Metallkomplexes an den zweiten Reaktanden stehen unterschiedliche Strategien zur Verfügung. Dabei werden allgemein Paare miteinander korrespondierender chemischer Gruppen verwendet, die miteinander eine kovalente chemische Bindung ausbilden können. Diese chemischen Gruppen, die hier auch als Ankergruppen bezeichnet werden, gehören einer ersten Ankergruppenspezies oder einer zweiten Ankergruppenspezies an, wobei Ankergruppen der ersten Ankergruppenspezies mit Ankergruppen der zweiten Ankergruppenspezies eine kovalente Bindung ausbilden können, nicht aber Ankergruppen einer ersten Ankergruppenspezies untereinander oder Ankergruppen einer zweiten Ankergruppenspezies untereinander.

Nachfolgend wird zunächst die einseitigen Verknüpfung (A), dann die zweiseitige Verknüpfung (Querverknüpfung) (B) erläutert.

A. Bei einer ersten Strategie der einseitigen kovalenten Verknüpfung des organischen Metallkomplexes an den zweiten Reaktanden weist der Ligand des Metallkomplexes eine Ankergruppe einer ersten Ankergruppenspezies auf, die der kovalenten Bindung des Metallkomplexes über den Liganden an das Polymer dient. Der zweite Reaktand weist mindestens eine Ankergruppe einer zweiten Ankergruppenspezies auf, die zur Bindung des zweiten Reaktanden an die Ankergruppe des Liganden des Metallkomplexes geeignet ist. Die Bindung des Metallkomplexes an das Polymer erfolgt durch Reaktion der Ankergruppen des Liganden des Metallkomplexes mit einer zweiten Ankergruppe eines zweiten Reaktanden.

Bei einer zweiten Strategie der einseitigen kovalenten Verknüpfung des organischen Metallkomplexes an den zweiten Reaktanden nimmt ein dritter Reaktand an der ersten Reaktion teil, der auch als "Spacer"-Molekül bezeichnet werden kann.

Dabei weist der Ligand des Metallkomplexes eine Ankergruppe einer ersten Ankergruppenspezies auf, die zur kovalenten Einbindung des Metallkomplexes über den Liganden in die Matrix über eine zweite Ankergruppe geeignet ist. Der zweite Reaktand weist eine Ankergruppe einer ersten Ankergruppenspezies auf, die der Bindung des zweiten Reaktanden an eine zweite Ankergruppe dient, so dass der Metallkomplex nicht unmittelbar an den zweiten Reaktanden binden kann. Zur Ausbildung einer kovalenten Bindung zwischen dem Ligand des Metallkomplexes und zweitem Reaktanden wird ein dritter Reaktand zugegeben, der zwei Ankergruppen einer zweiten Ankergruppenspezies aufweist, wobei jede dieser Ankergruppen des dritten Reaktanden mit je einer ersten Ankergruppe (nämlich des Metallkomplexes und des zweiten Reaktanden) eine kovalente Bindung eingehen kann. Somit erfolgt die Bindung des Metallkomplexes an das Polymer über den Liganden durch Reaktion der Ankergruppe des Liganden des Metallkomplexes und durch Reaktion der Ankergruppe des zweiten Reaktanden mit demselben dritten Reaktanden, so dass es zu einer Anbindung des Metallkomplexes an das Polymer kommt.

B. Bei einer ersten Strategie der zweiseitigen kovalenten Verknüpfung des organischen Metallkomplexes an den zweiten Reaktanden weist der Metallkomplex mindestens zwei Ankergruppen einer ersten Ankergruppenspezies auf, die der kovalenten Bindung des Metallkomplexes über die Liganden an das Polymer dienen. Der zweite Reaktand weist mindestens eine Ankergruppe einer zweiten Ankergruppenspezies auf, die zur Bindung des zweiten Reaktanden an eine erste Ankergruppe des Liganden des Metallkomplexes geeignet ist. Die Bindung des Metallkomplexes an das Polymer erfolgt durch Reaktion der mindestens zwei Ankergruppen des Metallkomplexes mit je einer zweiten Ankergruppe eines zweiten Reaktanden.

Bei einer zweiten Strategie der kovalenten Verknüpfung des organischen Metallkomplexes an den zweiten Reaktanden nimmt ein dritter Reaktand als "Spacer"-Molekül an der ersten Reaktion teil.

Dabei weist der Metallkomplex mindestens zwei Ankergruppen einer ersten Ankergruppenspezies auf, der zur kovalenten Einbindung des Metallkomplexes über den Liganden in die Matrix über eine zweite Ankergruppe geeignet ist. Der zweite Reaktand weist eine Ankergruppe einer ersten Ankergruppenspezies auf, die der Bindung des zweiten Reaktanden an eine zweite Ankergruppe dient, so dass der Metallkomplex nicht unmittelbar an den zweiten Reaktanden binden kann. Zur Ausbildung einer kovalenten Bindung zwischen dem Ligand des Metallkomplexes und zweitem Reaktanden wird ein dritter Reaktand zugegeben, der zwei Ankergruppen einer zweiten Ankergruppenspezies aufweist, wobei jede dieser Ankergruppen des dritten Reaktanden mit je einer ersten Ankergruppe (nämlich des Metallkomplexes und des zweiten Reaktanden) eine kovalente Bindung eingehen kann. Somit erfolgt die Bindung des Metallkomplexes in das mehrdimensionale Netzwerk über den Liganden durch Reaktion der Ankergruppe des Liganden des Metallkomplexes und durch Reaktion der Ankergruppe des zweiten Reaktanden mit demselben dritten Reaktanden, so dass es zu einer Querverknüpfung des Metallkomplexes kommt.

Der dritte Reaktand ("Spacer"-Molekül), kann z. B. eine Alkylkette einer gewünschten Kettenlänge sein, das an zwei voneinander beabstandeten Molekülteilen, z. B. einander gegenüberliegenden Enden, je eine Ankergruppe aufweist, der die Anbindung an Metallkomplex bzw. zweiten Reaktanden vermittelt. Neben Alkylketten sind auch Aryl-, Heteroaryl-, Alkenyl-, Alkinyl-, Trialkylsilyl-und Triarylsilyl-Gruppen bzw. substituierte Alkyl-, Aryl-, Heteroaryl- und Alkenyl-Gruppen, optional mit Substituenten wie Halogenen, niedrigen Alkylgruppen und/oder elektronenschiebenden und - ziehenden Gruppen, sowie gängigen Ladungstransporteinheiten wie beispielsweise Arylamine, Carbazole, Benzimidazole, Oxadiazole etc. möglich. Die Substituenten können auch zu anellierten Ringsystemen führen.

Bevorzugter Weise sind der Metallkomplex und der zweite Reaktand in einem (insbesondere zur OLED-Bauteilherstellung) gängigen organischen Lösemittel löslich. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol und Tetrahydrofuran. In einer bevorzugten Ausgestaltung der Erfindung ist das gebildete mehrdimensionale Netzwerk mit querverknüpften organischen Metallkomplexen unlöslich, was insbesondere die Ausbildung einer Struktur mehrerer übereinanderliegender Schichten eines derartigen mehrdimensionalen Netzwerks in einfacher Weise möglich macht.

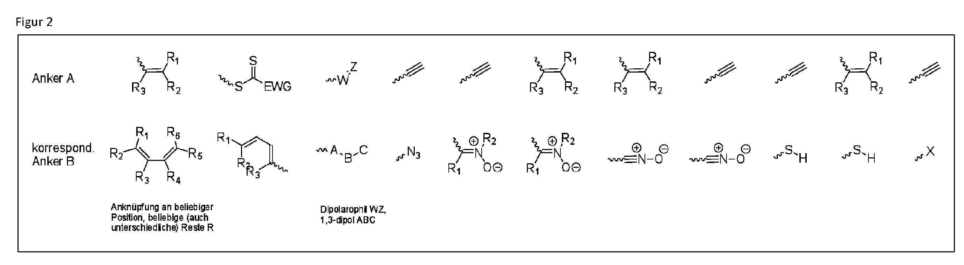

Die erste und zweite Ankergruppe können insbesondere ausgewählt sein aus der in Figur 2 gezeigten Gruppe chemischer Reste. Sofern es sich bei dem Metallkomplex um einen Emitter handelt, steht die Ankergruppe bevorzugter weise nicht in Konjugation zum Emittersystem, um die Emission des Komplexes nicht zu beeinflussen.

Grundsätzlich kann jedweder organischer Übergangsmetallkomplex in dem Verfahren verwendet werden, der an mindestens einem seiner organischen Liganden eine erste Ankergruppe trägt. Insbesondere weist der Metallkomplex neben der ersten Ankergruppe mindestens ein Metallzentrum und mindestens einen Liganden auf. Der Metallkomplex kann ein- oder mehrkernig (zwei-, drei-, vierkernig, etc.) sein und kann einen oder mehrere Liganden tragen. Die Liganden können ein- oder mehrzähnig sein. Sofern ein einkerniger Komplex nur einen Liganden trägt, ist dieser Ligand mehrzähnig. Wenn der Komplex nicht neutral ist, ist ein entsprechendes Gegenion bereitzustellen, das aber bevorzugt nicht an der ersten Reaktion wie hier beschrieben teilnimmt.

Bei der ablaufenden Reaktion werden die Liganden am Metallzentrum nicht ausgetauscht oder durch andere Liganden ersetzt, die ablaufende Reaktion findet ausschließlich direkt am Liganden bzw. in der Ligandensphäre statt, wobei die Grundstruktur des Metallkomplexes unverändert bleibt.

Die ablaufende Reaktion stellt eine kovalente Verknüpfung dar, wobei die durch die Reaktion entstehenden neuen kovalenten Bindungen bevorzugt zwischen Nichtmetall-Elementen ausgebildet werden.

Bevorzugte organische Metallkomplexe sind beispielsweise Lichtemitter, die in optoelektronischen Bauteilen, wie OLEDs eingesetzt werden können. Eine weitere Gruppe bevorzugte Metallkomplexe sind Halbleiter. Derartige emittierende und halbleitende Metallkomplexe sind im Stand der Technik bekannt.

Die Anzahl der Ankergruppen an einem Metallkomplex ist abhängig davon, ob der Metallkomplex einseitig oder mindestens zweiseitig kovalent an ein Polymer gebunden werden soll.

Für eine einseitige Bindung eines Metallkomplexes an ein Polymer weist der Metallkomplex eine Ankergruppe auf.

Mindestens ein Ligand des Metallkomplexes weist eine erste Ankergruppe auf. Insgesamt weist ein Metallkomplex für eine mindestens zweiseitige Bindung mindestens zwei Ankergruppen bevorzugt einer Ankergruppenspezies auf, die an einem oder bevorzugt auf zwei Liganden des Metallkomplexes verteilt angeordnet sein können. Es ist somit auch möglich, dass mehrere Liganden eines Metallkomplexes eine oder mehrere Ankergruppen aufweisen, wobei die Anzahl der Ankergruppen an dem Metallkomplex und an dem zweiten Liganden den Querverknüpfungsgrad bestimmt.

Das in einer bevorzugten Ausgestaltung des Verfahrens bei Bindung eines Metallkomplexes an mehr als ein Polymer (mindestens zweiseitige Bindung) gebildete mehrdimensionale Netzwerk ist ein zweidimensionales oder dreidimensionales Netzwerk. Bevorzugt ist ein dreidimensionales Netzwerk.

Der in dem Verfahren verwendete zweite Reaktand kann aus der Gruppe bestehend aus einem Monomer, einem Oligomer und einem Polymer ausgewählt sein. Als Monomer werden hier niedermolekulare, reaktionsfähige Moleküle bezeichnet, die zu molekularen Ketten oder Netzen, zu unverzweigten oder verzweigten Polymeren, reagieren können. Beispiele sind gängige Monomere wie Styrol, Ethylen, Propylen, Vinylchlorid, Tetrafluorethylen, Acrylsäuremethylester, Methacrylsäuremethylester, Bisphenol A/Phosgen, Ethylenglykole, Terephthalsäuren und Organochlorsilane. Als Oligomer wird hier ein Molekül bezeichnet, die aus 2 bis zu 30 strukturell gleichen oder ähnlichen Einheiten aufgebaut ist. Beispiele für Oligomere sind Oligoethylen, Oligopropylen, Oligovinylchlorid, Oligotetrafluorethylen, Oligoacrylsäuremethylester, Oligomethacrylsäuremethylester, Oligocarbonate, Oligoethylenglykol, Oligoethylenterephthalat, Oligo(organo)siloxane. Polymere sind Moleküle, die aus mindestens 10, bevorzugt mindestens 15, stärker bevorzugt aus mindestens 20 und am meisten bevorzugt aus mindestens 30 strukturell gleichen oder ähnlichen Einheiten aufgebaut sind. Beispiele für Polymere sind Polystyrol, Polyethylen, Polypropylen, Polyvinylchlorid, Polytetrafluorethylen, Polyacrylsäuremethylester, Polymethacrylsäuremethylester, Polycarbonate, Polyethylenglykol, Polyethylenterephthalat und Poly(organo)siloxane.

Bisher ist eine Querverknüpfung nur zwischen Polymeren bekannt, die mit Metallkomplexen verbunden sind, wobei immer nur Polymere mit sich selbst eine Querverknüpfungsreaktion eingehen, also nur homo-querverknüpft werden. Demgegenüber wird erfindungsgemäß nur durch die Ausbildung einer Bindung an den Liganden des Metallkomplexes eine Querverknüpfung ausgelöst, wodurch die entsprechenden Polymere mit dem Metallkomplex hetero-querverknüpft werden.

Die Beschreibung betrifft mit anderen Worten Materialien, insbesondere flüssig-prozessierbare optoelektronische Materialien, die durch ihren speziellen Aufbau gleichzeitig sowohl die kovalente Anbindung eines Metallkomplexes, beispielsweise eines hocheffizienten Emitter-Metallkomplexes, an einen entsprechend funktionalisierten zweiten Reaktanden in Form eines Polymers, als auch optional dessen Quervernetzung und somit Unlöslichkeitsmachung gewährleistet.

In einer bevorzugten Ausführungsform der Erfindung wird neben dem Metallkomplex, dem zweiten Reaktanden und optional dem dritten Reaktanden, ein vierter Reaktand in der ersten Reaktion des Verfahrens eingesetzt, wobei es sich um eine loch- oder elektronenleitende chemische Gruppe und/oder um eine ladungsblockierende chemische Gruppe handelt, die als Ladungstransport- bzw. Ladungsblockiereinheit ebenfalls quervernetzt werden kann. Beispiele für loch- oder elektronenleitende chemische Gruppen sind Arylamine wie N,N'-bis(naphthalen-1-yl)-N,N'-bis(phenyl)-benzidin, N,N'-bis(naphthalen-1-yl)-N,N'-bis(phenyl)-2,2'-dimethylbenzidin, Carbazole wie 4,4-Bis(carbazol-9-yl)biphenyl, 1,3-Bis(carbazol-9-yl)benzol, Benzimidazole wie 1,3,5-Tris(1-phenyl-1H-benzo[d]imidazol-2-yl)benzol, Oxadiazole wie 2-(4-Biphenyl)-5-(4-tert-butylphenyl)-1,3,4-oxadiazol, Triazole wie 3-(4-Biphenyl)-4-phenyl-5-tert-butylphenyl-1,2,4-triazol, 4-(Naphthalen-1-yl)-3,5-diphenyl-4H-1,2,4-triazol.

Zum Zwecke der Anbindung an das Polymer und/oder den Metallkomplex weist der vierte Reaktand ebenfalls mindestens eine Ankergruppe der ersten und/oder zweiten Ankergruppenspezies auf, abhängig davon, ob der vierte Reaktand an den Metallkomplex oder den zweiten Reaktanden gebunden werden soll.

Für die erste Reaktion können dabei insbesondere solche im Stand der Technik als "Click-Chemie" bezeichnete, energetisch begünstigte Reaktionen verwendet werden, die spezifisch verlaufen und ein einzelnes Produkt ergeben (H. C. Kolb, M. G. Finn, K. B. Sharpless, Angew. Chem. Int. Ed. 2001, 40, 2004 -2021). Die "Click-Chemie" umfasst somit Reaktionen, die mit hohen Ausbeuten durchführbar sind, ein breites Anwendungsspektrum aufweisen, (stereo)spezifisch ablaufen, einfache Reaktionsbedingungen (möglichst unempfindlich gegen Wasser und Sauerstoff) aufweisen, einfach entfernbare, möglichst ungefährliche Nebenprodukte und Reagenzien (falls überhaupt) aufweisen, in umweltfreundlichen und/oder leichtentfernbaren Lösungsmitteln wie Wasser oder lösungsmittelfrei ablaufen und/oder eine einfache Aufreinigung (Extraktion, Phasentrennung, Destillation oder Kristallisation - möglichst keine Chromatographie) oder gar keine Aufreinigung benötigen.

"Click"-Reaktionen sind zumeist stark thermodynamisch begünstigt, mit oft mehr als 20 kcal mol⁻¹, was in schnellem Umsatz mit hoher Selektivität zu einem einzelnen Produkt resultiert. Mit Click-Reaktionen werden meist Kohlenstoff-Heteroatom Bindungen gebildet.

Insbesondere können nucleophile Substitutionen, besonders Ringöffnung von gespannten, elektrophilen Heterozyklen wie Epoxide und Aziridine, Carbonyl-Chemie des "Non-Aldol"-Typs wie die Bildung von aromatischen Heterocyclen oder Hydrazonen, Additionen an Kohlenstoff-Kohlenstoff-Doppelbindungen wie die oxidative Bildung von Epoxiden und Aziridinen, Dihydroxylierung und Michael-Additionen, sowie Cycloaddition an ungesättigte C-C-Bindungen, besonders 1,3-dipolare Cycloadditionen und Diels-Alder-Reaktionen gemäß der Erfindung verwendet werden. Weitere Beispiele für solche Reaktionen sind Kreuzkupplungsreaktionen zur Knüpfung von C-C-Bindungen wie die Ullmann-Reaktion, die Sonogashira-Reaktion und die Glaser-Kupplung. Alle diese Reaktionen sind dem Fachmann bekannt.

Für die Erfindung sind insbesondere solche Reaktionen bevorzugt, die ohne den Zusatz eines weiteren Reaktanden (also über den ersten, zweiten und ggf. dritten und ggf. vierten hinaus), dass heißt höchstens durch einen die weitere Anwendung nicht weiter störenden Katalysator auskommen. Beispiele für solche Reaktionen sind neben den oben erwähnten 1,3-dipolaren Cycloadditionen und Diels-Alder-Reaktionen Nitron-Alkin-, Nitriloxid-Alkin-, Thiol-En-, Thiol-In-, Thiol-Isocyanat, Tetrazol-Alken- und andere in der chemischen Literatur als Click-Reaktionen bekannte Verfahren.

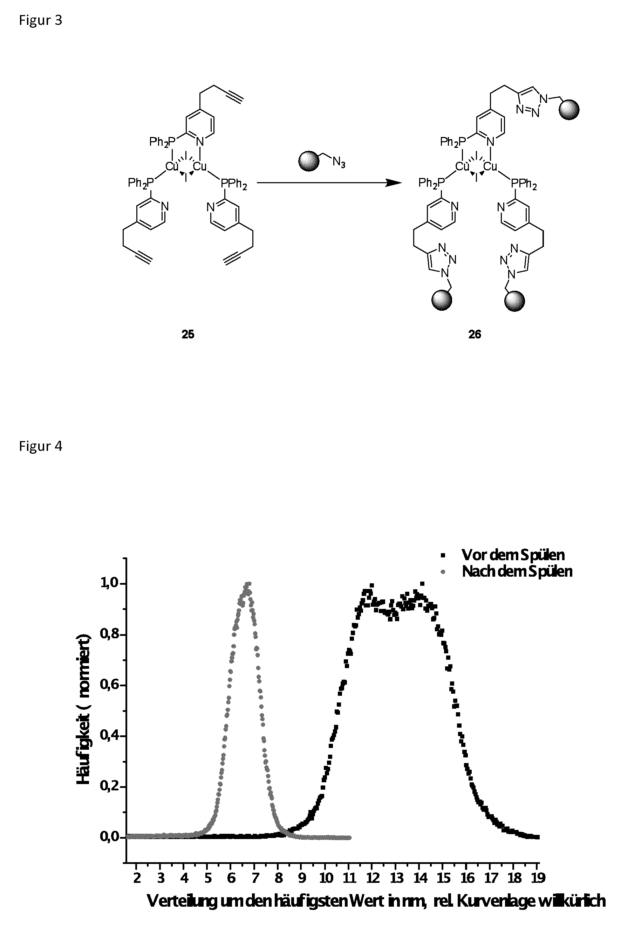

Wie eingangs beschrieben findet die erste Reaktion des Verfahrens in Gegenwart eines Katalysators zur Katalyse der Reaktion statt. Der Katalysator ist zugleich Edukt/Reaktand und Katalysator. Dabei weist der Metallkomplex den Katalysator auf, d. h. das im organischen Metallkomplex enthaltene Metallzentrum dient gleichzeitig als Katalysator, so dass eine selbstkatalysierte Bindung des Metallkomplexes an das Polymer stattfindet. Als Beispiel hierfür ist in Figur 3 die Kupfer-katalysierte Clickreaktion zwischen einem terminalen oder aktivierten Alkin als erster Ankergruppe einer ersten Ankergruppenspezies eines Metallkomplexes und einem Azid als Ankergruppe einer zweiten Ankergruppenspezies eines Polymers dargestellt.

Mittels eines Cu(I) Katalysators verläuft z. B. die klassische 1,3-dipolare Cycloaddition (Huisgen-Cyclisierung), die ansonsten recht hohe Temperaturen erfordert, regiounspezifisch verläuft und sich daher grundsätzlich nicht als "Click"-Reaktion eignet (V. V. Rostovtsev, et al., Angew. Chem. Int. Ed. 2002, 41, 2596-2599; C. W. Tornøe, et al., J. Org. Chem. 2002, 67, 3057) gegenüber der klassischen Cyclisierung bis zu 10⁷ mal schneller, regioselektiv (nur das 1,4-Regioisomer wird gebildet), auch in Wasser, bei Raumtemperatur und ist dabei unempfindlich gegenüber den meisten anderen funktionellen Gruppen, wie beispielsweise Alkoholen, Säuren und Säurederivaten, Carbonylverbindungen, Halogenen etc.

In einer bevorzugten Ausführungsform ist der Metallkomplex ein Cu(I) oder Cu(II)-Komplex, so dass die Reaktion selbstkatalytisch erfolgt. Andere mögliche Katalysatoren als Teil des Metallkomplexes sind Re, Fe, Ru, Os, Co, Rh, Ir, Ni, Pd, Pt, Ag, Au, Zn, Cd, Hg, Sn und/oder Pb.

Die Reaktion zwischen Metallkomplex und zweitem Reaktanden verläuft bevorzugt bei einer Temperatur, die größer ist als Raumtemperatur. Bevorzugt sind mindestens 50 °C, besonders bevorzugt sind Temperaturen von 80 °C bis 120 °C. Die für die jeweilige Reaktionstemperatur benötigte Reaktionszeit kann von einem Fachmann leicht bestimmt werden. Im Allgemeinen ist mit einer Reaktionszeit von 1 Minute bis 60 Minuten, bevorzugt von 10 Minuten bis 30 Minuten zu rechnen, so dass der Metallkomplex immobilisiert und damit stabilisiert und unlöslich ist. Die thermische Aktivierung kann dabei auch durch Bestrahlung mit Mikrowellen erfolgen, wodurch die Reaktionszeiten meist deutlich verkürzt auf kleiner als 1 Minute werden können.

Ist eine Ankergruppe, z. B. ein Alkin-Linker, in Konjugation zu einem organischen Liganden des Metallkomplexes vorhanden und wird ein aromatisches Azid als komplementäre Ankergruppe verwendet, so lassen sich die Emissionsfarben solcher emittierender Komplexe, die auf Charge-Transferübergängen zwischen den Metallionen und den Liganden beruhen, beeinflussen. Bevorzugt sind in diesem Zusammenhang Metallkomplexe mit drei Liganden oder mehr (z. B. vier, fünf oder sechs Liganden), da damit drei Anknüpfstellen oder mehr (z. B. vier, fünf oder sechs Anknüpfungsstellen) vorhanden sind. Somit lassen sich die Komplexe auf diese Weise sowohl an die Polymere anknüpfen, als auch mit Loch- oder Elektronenleitern (vierten Reaktanden) verbinden. Die optischen, mechanischen und elektrischen Eigenschaften der so erhaltenen Substanzen lassen sich damit über die jeweilige Zusammensetzung des Azid-Gemisches beeinflussen.

Sofern das hier beschriebene Verfahren gemäß einer bevorzugten Ausführungsform der Erfindung zu einem unlöslichen Produkt führt ist es möglich, mehrere Schichten immobilisierter Metallkomplexe in einfacher Weise übereinander anzuordnen, ohne dass z. B. orthogonale Lösungsmittel verwendet werden müssen.

Zur Herstellung einer Mehrschichtanordnung wird nach der oben beschriebenen ersten Reaktion eine zweite Reaktion durchgeführt. Diese zweite Reaktion umfasst einen fünften Reaktanden in Form eines organischen Metallkomplexes und einen sechsten Reaktanden zur Ausbildung eines bevorzugt unlöslichen mehrdimensionalen Netzwerkes, wobei der Metallkomplex während der zweiten Reaktion in dem sich bildenden mehrdimensionalen Netzwerk durch Ausbildung kovalenter Bindungen querverknüpft wird. Hinsichtlich spezieller Ausgestaltungen der zweiten Reaktion gilt das für die erste Reaktion gesagte entsprechend.

Dabei kann der fünfte Reaktand der zweiten Reaktion zu dem ersten Reaktanden der ersten Reaktion identisch oder verschieden sein. Ebenso kann der sechste Reaktand der zweiten Reaktion zu dem zweiten Reaktanden der ersten Reaktion identisch oder verschieden sein.

Die gemäß einer bevorzugten Ausgestaltung des Verfahrens erfolgende Quervernetzung erlaubt eine schnelle und einfache Anordnung beliebig vieler photoaktiver Schichten, deren Löslichkeit nicht wie in bisherigen Systemen exakt aufeinander abgestimmt werden müssen. Dies hat eine deutliche Vereinfachung in der Verarbeitung zur Folge, da die Auswahl der einzelnen aktiven Schichten nicht mehr bezüglich der Löslichkeit zueinander orthogonal sein muss, sondern nahezu unabhängig voneinander kombiniert werden kann. Dies erlaubt somit die sequentielle Auftragung beliebig vieler unterschiedlicher Schichten und führt dadurch zu einer signifikanten Verbesserung der Effizient und Haltbarkeit.

In einer bevorzugten Ausgestaltung des Verfahrens sind die Ankergruppen der ersten und zweiten Ankergruppenspezies in jeweils äquimolaren Mengen vorhanden, so dass alle Ankergruppen kovalente Bindungen mit komplementären Ankergruppen eingehen können.

Weiterhin betrifft die Beschreibung die Verwendung des mittels des hier beschriebenen Verfahrens erhaltenen Polymers, insbesondere als Emitter oder Absorber in einem optoelektronischen Bauelement.

Insbesondere in Fällen, in denen der Metallkomplex ein Emitter-Metallkomplex ist, der in optoelektronischen Bauelementen eingesetzt werden kann und soll, besteht ein Vorteil der Erfindung in der Stabilisierung der Geometrie des Emitter-Metallkomplexes durch die Immobilisierung der Quervernetzung.

Es ist bekannt, dass eine Änderung der Geometrie eines Emitterkomplexes bei der Anregung aus dem Grundzustand in den ersten angeregten Zustand zu größeren Verschiebungen der Energiepotentiale und zu größeren Wahrscheinlichkeiten für nicht-strahlende Relaxationsprozesse führt. Die Geometrie des angeregten Zustands sollte sich daher nicht von derjenigen des Grundzustands unterscheiden. Die mit der Erfindung erreichte räumliche/sterische Stabilisierung von Emittern führt somit zu einer Effizienzsteigerung von Emittern als Metallkomplexe.

Mittels der in der Peripherie der Liganden der als Metallkomplexe, z. B. als Emitterkomplexe, angebundenen Ankergruppen für die verknüpfenden Click-Reaktionen wird die mögliche Bewegung der Liganden des Metallkomplexes zueinander eingeschränkt. Die Komplexe werden somit fixiert und stabilisiert. Die Übergangswahrscheinlichkeiten für nicht strahlende Prozesse werden im Gegensatz zu "freien" Komplexen durch Rotation und Verdrillung reduziert: Die Emissions-Quantenausbeute der Emitter werden erhöht. Gleichzeitig führt die Fixierung zu einer maximalen Ausnutzung des energetischen Abstandes zwischen Grund- und erstem angeregten Zustand. Hierdurch kann im Vergleich zum "freien", d. h. nicht quervernetzten Komplex eine Blauverschiebung des Emissionsspektrums stattfinden, da die Besetzung von Rotations- und Schwingungszuständen weniger wahrscheinlich und der Energieunterschied zwischen Grund- und erstem angeregten Zustand (direkte vertikale Anordnung der Potentialkurven, vgl. Franck-Condon-Prinzip, das dem Fachmann bekannt ist) maximiert wird.

Neben der Schichtstabilisierung und dem möglichen Einbau von definierten Loch- und Elektronenleitern verbessert die Erfindung darüber hinaus die Effizienz von optoelektronischen Bauteilen: Durch die sterische Hinderung der Metallkomplexe werden die Überlappintegrale zwischen nicht zur Emission genutzten Zuständen kleiner, die Besetzung von Rotations- und Schwingungszuständen weniger wahrscheinlich. Die Stabilität der Komplexe steigt durch die Verhinderung von Bindungsbrüchen und nicht-strahlenden Relaxationen durch freie Beweglichkeit der Liganden eines Metall-Emittersystems. Durch die Immobilisierung ist es möglich, die Emission eines gegebenen freien, also nichtvernetzten emittierenden Metallkomplexes in Richtung des oder in den blauen Spektralbereich zu verschieben.

Weiterhin betrifft die Beschreibung die Verwendung eines gemäß dem hier beschriebenen Verfahren hergestellten Polymers mit kovalent angebundenem Metallkomplex als Emitter oder Absorber in einem optoelektronischen Bauelement, sofern der Metallkomplex ein Licht-Emitter oder -Absorber ist.

Entsprechend betrifft die Beschreibung auch ein optoelektronisches Bauelement, aufweisend einen an ein Polymer kovalent gebundenen organischen Metallkomplex, wie hier beschrieben.

Das optoelektronische Bauelement kann eine organischen Leuchtdiode (OLEDs), lichtemittierenden elektrochemischen Zelle (LEECs oder LECs), OLED-Sensoren, optischen Temperatur-Sensoren, organischen Solarzellen (OSCs), organischen Feldeffekttransistoren, organischen Dioden, organischen Photodioden und "down conversion" Systeme betreffen. Derartige Bauelemente sind dem Fachmann bekannt.

Weiterhin betrifft die Beschreibung ein Verfahren zur Herstellung einer Schicht eines an ein Polymer gebundenen organischen Metallkomplexes, insbesondere einer dünnen Schicht mit einer Dicke von 75 nm bis 300 nm, insbesondere von 100 nm bis 250 nm, insbesondere zur Herstellung eines optoelektronischen Bauelements.

Das Verfahren ist abhängig davon, ob der Metallkomplex einseitig oder mindestens zweiseitig an das Polymer gebunden wird. Im ersten Fall erfolgt eine Flüssigprozessierung des Reaktionsproduktes, da die Löslichkeit des Metallkomplexes durch die Bindung an das Polymer erhöht wird. Im zweiten Fall kann das Auftragen eines Gemisches beider Reaktanden auf einen festen Träger mittels aller im Stand der Technik bekannter Methoden erfolgen, insbesondere mittels Inkjet-Printing, Dipping, Spincoating, Schlitzgießen oder Rakeln (Knife Coating). Das Reaktionsprodukt ist unlöslich.

Im ersten Fall kann die weitere Flüssigprozessierung des somit erhaltenen Kompositmaterials mittels aller im Stand der Technik bekannter Beschichtungs- und Druckverfahren erfolgen, insbesondere mittels Inkjet-Printing, Dipping, Spincoating, Schlitzgießen oder Rakeln (Knife Coating).

Im ersten Fall weist das Verfahren mindestens die folgenden Schritte auf: Zunächst wird ein Gemisch aus einem ersten Reaktanden in Form eines organischen Metallkomplexes und einem zweiten Reaktanden in Form eines Polymers in Lösung hergestellt. Gängige dabei verwendete organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol und/oder Propiophenon.

Der Metallkomplex wird während der dann durchgeführten ersten Reaktion an das Polymer einseitig gebunden, bzw. in einer bevorzugten Ausgestaltung, wie oben beschrieben, mehrseitig gebunden (quervernetzt). Dabei wird die Reaktion zwischen dem ersten Reaktanden und dem zweiten Reaktanden durch den Metallkomplex katalysiert.

Wie hierin beschrieben erfolgt die Ausbildung der einseitigen oder mindestens mehrseitigen Anbindung bevorzugt bei erhöhter Temperatur, bevorzugt zwischen 80 °C bis 120 °C.

Weiterhin betrifft die Beschreibung die Verwendung eines an ein Polymer gebundenen Metallkomplexes als Emittermaterial für ein optoelektronisches Bauelement, insbesondere als optoelektronische Tinte.

Weiterhin betrifft die Beschreibung einen organischen Metallkomplex mit mindestens einem Metallzentrum und mindestens einem organischen Liganden. Erfindungsgemäß weist der Metallkomplex eine, bevorzugt zwei, drei, vier, oder mehr Ankergruppen einer ersten Ankergruppenspezies zur Reaktion mit einer Ankergruppe einer zweiten Ankergruppenspezies zur einseitigen oder mehrseitigen Anbindung auf, wobei die Ankergruppe des Metallkomplexes während einer ersten Reaktion zu der Ankergruppe eines zweiten Reaktanden eine kovalente Bindung ausbilden kann.

Weiterhin betrifft die Beschreibung die Verwendung eines derartigen Metallkomplexes zur Anbindung und optional Quervernetzung und somit Immobilisierung des Metallkomplexes mit einem zweiten Reaktanden, insbesondere in Form eines Polymers, der eine Ankergruppe einer zweiten Ankergruppenspezies aufweist. Gleichzeitig betrifft die Erfindung die Verwendung eines Polymers zur Verbesserung der Löslichkeit eines Metallkomplexes bei der hier beschriebenen einseitigen Anbindung.

### Figuren

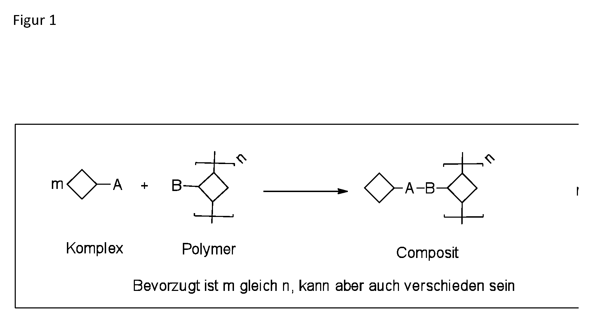

- Figur 1:: Allgemeines Schema für die Verknüpfung von organischen Metallkomplexen (erster Reaktand) mit einem Polymeren (zweiter Reaktand), die jeweils eine entsprechende Ankergruppen tragen, die die Bindung bzw. optional Quervernetzung des Metallkomplexes ermöglichen.
- Figur 2:: Ausgewählte Beispiele für Ankergruppen einer ersten und zweiten Ankergruppenspezies (jeweils in Zeilen angeordnet). Jeweils gegenüberliegend gezeigte Ankergruppen können, gebunden einerseits an den Metallkomplex und andererseits an den zweiten Reaktanden, eine kovalente Bindung zwischen den Reaktanden ausbilden und den Metallkomplex so anbinden und ihn ggf. immobilisieren. Erste und zweite Ankergruppenspezies werden hier als Anker A bzw. Anker B angesprochen. Dabei kann je nach Verwendung der hier dargestellte Anker A die erste oder zweite Ankergruppenspezies, und der Anker B entsprechend die zweite oder erste Ankergruppenspezies darstellen. Die Bedeutung der verwendeten Symbole ist wie folgt: R1-R6 können jeweils unabhängig voneinander Wasserstoff, Halogen sein oder Substituenten, die über Sauerstoff- (-OR*), Stickstoff- (-NR*₂) oder Siliziumatome (-SiR*₃) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carbonyle, Carboxylate und deren Ester, und CF₃-Gruppen. R1-R6 können optional auch zu annelierten Ringsystemen führen; R* = organischer Rest, der ausgewählt ist aus der Gruppe bestehend aus: Wasserstoff, Halogen oder Deuterium, sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen; X = Halogen, OSO₂Me, OSO₂Tolyl, OSO₂CF₃.
- Figur 3:: Reaktion für die Vernetzung eines Alkin-substituierten Kupferkomplexes mit einem polymeren Azid als zweitem Reaktanden, wobei die Reaktion selbstkatalysiert abläuft. Die gezeigte Kugel steht für Polystyrol als Beispiel für einen zweiten Reaktanden.
- Figur 4:: Histogramm des AFM-Bildes vor und nach dem Spülen mit Xylol (s. Beispiel 3). Die Höhen sind auf 1 normiert, die Lage der Histogramme auf der X-Achse willkürlich, aber maßstabsgetreu. Zur besseren Übersicht wurden die Histogramme nicht über einander, sondern nebeneinander angeordnet. Die Prozessierung erfolgte bei 40 °C, die Scan-Größe der zugrundeliegenden Aufnahmen beträgt 1 µm².
- Figur 5:: Photolumineszenzspektren von den Verbindungen 9.2 A-C (Pulvermessung, Raumtemperatur, unter normaler Atmosphäre) ("wavelength" = Wellenlänge).

### Beispiele

Die Erfindung besteht in einem Stabilisierungs-, Anbindungs- und optional Vernetzungsverfahren von Metallkomplexen durch Polymere, die aus einem oder mehreren Metallen und einem mindestens zweizähnigen, oder mehreren ein- oder mehrzähnigen Liganden bestehen. Erfindungsgemäß tragen der organische Metallkomplex und der zweite Reaktand komplementäre chemische Anker einer (ersten bzw. zweiten) Ankergruppenspezies, die in einer möglichst schnell und vollständig ablaufenden Reaktion kovalent miteinander verbunden werden. So können beispielsweise lumineszierende oder halbleitende Metallkomplexe z. B. für Anwendungen in der organischen Elektronik immobilisiert werden, um die Lebensdauer und Langzeitstabilität der entsprechenden Bauteile zu erhöhen.

### Beispiel 1

Für die beschriebene Erfindung sind solche Reaktionen bevorzugt, die neben dem Metallkomplex und dem zweiten Reaktanden ohne den Zusatz eines weiteren Reaktanden, dass heißt höchstens durch einen die Anwendung nicht weiter störenden Katalysator, auskommen. Beispiele für solche Reaktionen sind 1,3-dipolaren Cycloadditionen, Diels-Alder-Reaktionen, Nitron-Alkin-, Nitriloxid-Alkin-, Thiol-En-, Thiol-In-, Thiol-Isocyanat, Tetrazol-Alken- und andere in der chemischen Literatur als Click-Reaktionen bekannte Verfahren.

Es handelt sich um Reaktionen, die von dem im Metallkomplex enthaltenen Metall selbst katalysiert werden, was einer selbstkatalysierten Anbindung oder Quervernetzung entspricht. Ein Beispiel hierfür ist die Kupfer-katalysierte Clickreaktion zwischen einem terminalen oder aktivierten Alkin und einem Azid. Diese Reaktion liefert regioselektiv und in hohen Ausbeuten und Umsätzen 1,4-Triazole (s. Figur 2).

### Beispiel 1.1.: Cu-Komplex katalysierte Clickreaktion zwischen terminalen Alkinen und Aziden:

Phenylacetylen (103 mg, 1.0 mmol, 1.0 Äquiv.) und Benzylazid (133 mg, 1.0 mmol, 1.0 Äquiv.) wurden in einem mit einem Septum luftdicht verschließbaren Vial in 10 mL trockenem Dichlormethan gelöst. Der Cu-Komplex (katalytische oder stöchiometrische Mengen) wurde zugegeben, das Vial versiegelt und die Reaktion 2 Tage bei Raumtemperatur gerührt. Zum Entfernen des Katalysator-Komplexes wurde die Reaktionsmischung in 50 mL Methanol gegeben und 20 min gerührt. Der Komplex wurde abfiltriert und das Filtrat eingeengt. Entfernen des Lösungsmittels und Trocknen des Produkts im Hochvakuum ergab die Verbindung 1-Benzyl-4-phenyl-1H-1,2,3-triazol als hellgelben Feststoff in 95 % Ausbeute (245 mg, 0.95 mmol). Die Identität des Produkts wurde eindeutig durch NMR-Spektroskopie, Infrarotspektroskopie und hochauflösende Massenspektrometrie belegt.

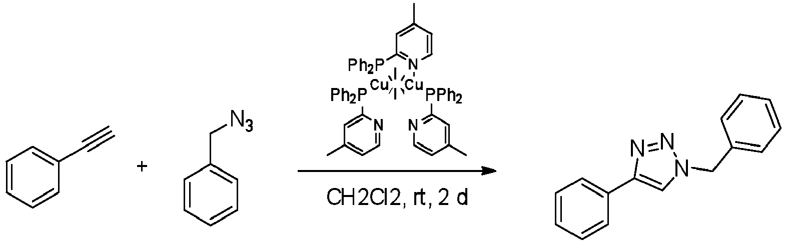

### Beispiel 1.2.: Cu-Komplex katalysierte Clickreaktion zwischen Cu-Alkin-Komplex und Aziden:

Der Cu-Komplex (1,341 g, 1.0 mmol, 1,0 Äquiv.) wurde in einem mit einem Septum luftdicht verschließbaren Vial in 10 mL trockenem Dichlormethan gelöst und Benzylazid (466 mg, 3,5 mmol, 3,5 Äquiv.) zugegeben. Die Reaktion wurde 12 Stunden lang bei Raumtemperatur gerührt, über einen Spritzenfilter filtriert und durch Eintropfen in Diethylether ausgefällt. Waschen des ausgefällten Feststoffs mit Diethylether und Trocknen des Produkts im Hochvakuum ergab die Verbindung Tris-(4-(2-(1-benzyl-1H-1,2,3-triazol-4-yl)ethyl)-2-(diphenylphosphino)pyridin)-di-kupfer-diiodid als hellgrünen Feststoff in 61 % Ausbeute (1,052 g, 0,61 mmol). Die Identität des Produkts wurde eindeutig durch NMR-Spektroskopie, Infrarotspektroskopie, Massenspektrometrie und Elementaranalyse belegt.

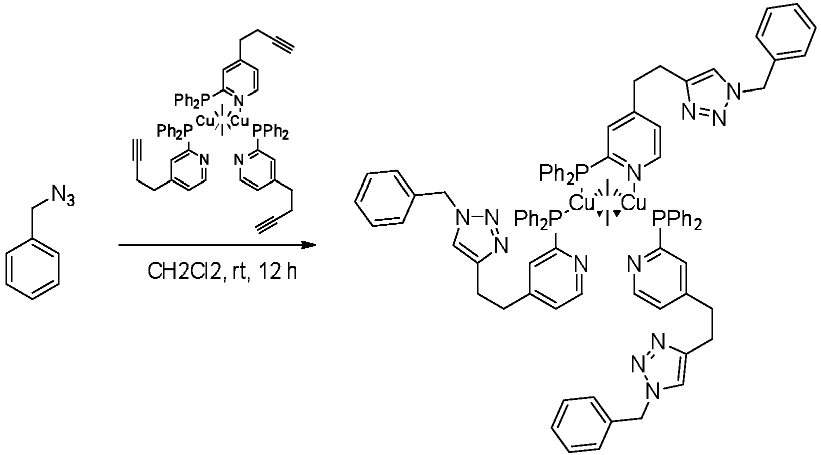

### Beispiel 1.3. Cu-Komplex katalysierte Clickreaktion zwischen Cu-Alkin-Komplex und Polyaziden zur Querverknüpfung:

Der Cu-Komplex (440 mg, 0.33 mmol, 1.0 Äquiv.) wurde als erster Reaktand in einem mit einem Septum luftdicht verschließbaren Vial in 10 mL trockenem Dichlormethan gelöst und mit Poly-(vinylbenzylazid-*alt*-styrol) (370 mg, 1,0 mmol, 3,0 Aquiv.) umgesetzt. Die Reaktion wurde 12 Stunden lang bei Raumtemperatur gerührt, wobei das Produkt als unlöslicher grünlicher Feststoff aus der Reaktionslösung ausfiel. Der Niederschlag wurde abgesaugt, mit 20 mL Dichlormethan, 20 mL Diethylether und 20 mL Methanol gewaschen und im Hochvakuum getrocknet. Das Produkt Poly-(4-(2-(1-(4-vinylbenzyl-1H-1,2,3-triazol-4-yl)ethyl)-2-(diphenylphosphino)pyridin)-alt-styrol @ Cul fiel als hellgrüner Feststoff in 66 % Ausbeute an (540 mg, 0,21 mmol) und stellt den quervernetzten Metallkomplex dar. Die Identität des Produkts wurde eindeutig durch Infrarotspektroskopie und Elementaranalyse belegt.

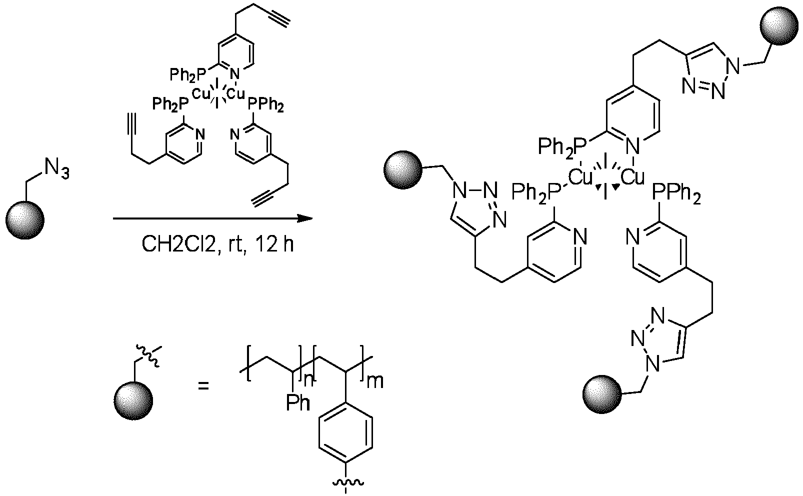

Es wurde gezeigt, dass eine solche Reaktion unlösliche, quervernetzte Metallkomplexe (KompositMaterialien) liefert. Sowohl der Ausgangskomplex 25 als auch das Produkt 26 (s. Figur 2). verfügen dabei über eine gelbe Lumineszenz, deren Spektrum durch die Reaktion nicht weiter beeinflusst oder gestört wird, da die Ankergruppen nicht in Konjugation zum Emittersystem stehen.

Nach dem Auftragen auf einen Objektträger mit einer Rakel-Apparatur (alle weiteren bekannten Druck- oder Beschichtungsverfahren wie bspw. Spincoating, Schlitzgießen oder Ink-Jet sind ebenfalls möglich) zu einer dünnen Schicht und einem Aushärten durch 30-minütiges Erhitzen auf 100 °C wurde diese Schicht stabilisiert und unlöslich. Mit einem derartigen Verfahren lassen sich auf einfachem Wege Mehrschichtanordnungen realisieren, für deren Umsetzung ansonsten orthogonale Lösungsmittel oder photochemische Aushärtungsschritte benötigt werden. Zusätzlich sorgt diese Quervernetzung für eine Stabilisierung und Fixierung der geometrischen Struktur der Metallkomplexe, wodurch eine Bewegung der Liganden und somit eine Strukturänderung der angeregten Moleküle verhindert und eine Effizienzminderung durch strahlungslose Relaxationspfade wirkungsvoll unterbunden wird.

### Beispiel 2

Die Erfindung betrifft in einer bevorzugten Ausführungsform die Herstellung von neuartigen optoelektronischen Tinten als Emittermaterial für organische Leuchtdioden als optoelektronisches Bauelement. Die Tinte beruht dabei in einer Ausführungsform auf elektrolumineszierenden Kupfer(I)-Komplexen, bei denen Diphenylphosphinpyridine, Diphenylphosphinchinoline und verwandte Heterozyklen als Liganden verwendet werden. Diese zweizähnigen Liganden bilden mit Kupfer(I)-iodid mehrkernige Komplexe mit einem Ligand-Metalliodid-Verhältnis von 3:2.

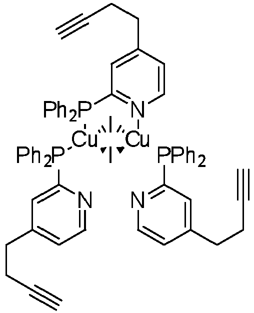

### Struktur von Tris-(4-Butinyl-2-diphenylphosphinopyridin)-bis-(kupferiodid)

Wie in Versuchen gezeigt wurde, lassen sich diese Ligandensysteme mit Alkin-Ketten wie 4-Butin substituieren und als Kupferkomplex (erster Reaktand mit erster Ankergruppe) in einer *Click-*Reaktion mit Aziden kuppeln. Mit dieser Reaktion lassen sich sowohl niedermolekulare als auch polymere Azide als zweiter Reaktand umsetzen, so dass beispielsweise vernetzte, Kupfer-haltige Polymere synthetisiert werden können, die die elektrolumineszierenden Eigenschaften der Metallkomplexe mit den Vorteilen der einfachen flüssigen Verarbeitbarkeit der Polymere verbinden und nach einem Temperschritt robuste, unlösliche Schichten ergeben. Im Falle der einseitigen Anbindung können die Vorteile einer flüssigen Prozessierung der hierdurch entstehenden löslichen Metallkomplex-Polymer-Kompositmaterialien (kurz Kompositmaterialien) genutzt werden, bei mehrseitiger Anbindung ergeben sich quervernetzte unlösliche Schichten zur Realisierung von Mehrschichtaufbauten.

Weiterhin kann diese Reaktion auch mit weiteren Ligandenklassen durchgeführt werden. Gleichzeitig können neben der Anbindung oder Quervernetzung weitere Materialfunktionen in die Tinte implementiert werden. Dafür können *Click*-Reaktionen genutzt werden, um funktionelle Halbleiter (als dritter Reaktand), die lochleitende beziehungsweise elektronenleitende Eigenschaften haben, an die Komplexe zu knüpfen. Wird die Ankergruppe, z. B. der Alkin-Linker, in Konjugation zu den organischen Liganden angeknüpft und aromatische Azide verwendet, so lassen sich die Emissionsfarbe der Komplexe, die auf Charge-Transferübergängen zwischen den Metallionen und den Liganden beruht, beeinflussen. Da die dimeren Komplexe jeweils drei Liganden und damit drei Anknüpfstellen enthalten, lassen sich die Komplexe auf diese Weise sowohl an die Polymere anknüpfen, als auch mit Loch- oder Elektronenleitern verbinden. Die optischen, mechanischen und elektrischen Eigenschaften der so erhaltenen Substanzen lassen sich damit über die jeweilige Zusammensetzung des Azid-Gemisches beeinflussen. Über Roboter-gestützte High-Throughput-Screening-Verfahren lassen sich diese Parameter der Tinte optimieren. Bei der Verwendung verschiedener mit Alkin substituierter Metallkomplexe lassen sich so organische Leuchtdioden in verschiedenen Farben realisieren, durch geeignete Farbmischung der entsprechenden Metallkomplexe können so Weißlicht-OLEDs erzeugt werden.

So lassen sich Emitter (insbesondere solche, die mittels eines vierten Reaktanden zum Transport oder zur Blockierung elektrischer Ladungen dargestellt wurden, der eine Ankergruppe der ersten oder zweiten Ankergruppenspezies aufweist) mit einer optimalen Mischung aus Lochleitern, Elektronenleitern und einem Polymer zu einer optoelektronischen Tinte verknüpfen.

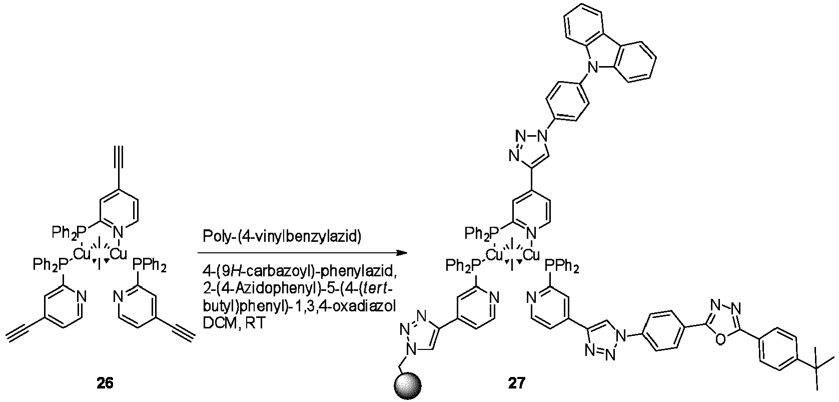

Die in 27 gezeigte Kugel steht für Polystyrol, kann aber jedes andere Polymer als zweiten Reaktanden repräsentieren.

Dabei dient der PyrPHOS-Komplex (Pyridyldiphenylphosphin = PyrPHOS) selbst als Katalysator für die *Click*-Reaktion. Bei Verwendung von polymeren Aziden mit einem Rückgrat aus Polystyrol oder Polyethylenglykol tritt durch Reaktion über nur eine Ankergruppe des Metallkomplexes eine einseitige Anbindung auf.

Wie durch Photolumineszenz-Spektroskopie gezeigt werden konnte, wird die gelbe Emissionsfarbe der Kupfer-PyrPHOS-Komplexe weder durch Variation der Ladungstransport- oder Blockiereinheiten, noch durch die Anknüpfung an die Polymere beeinflusst. Das Emissionsmaximum der PyrPHOS-Systeme liegt bei 550 nm. Dass sich die per Photolumineszenz beobachtete Emissionsfarbe auch im OLED reproduzieren lässt, wurde in einer Einschichtanordnung durch Mischen des Kompositmaterials mit dem Lochleiter CBP gezeigt.

### Beispiel 3

### Auftragen mit der Rakel (Knife Coating):

Mit dem Rakel-Verfahren lassen sich dünne Schichten mithilfe eines keilförmigen Beschichtungsmessers herstellen. Dazu wird die Substanz in Lösung auf das Substrat aufgetragen und durch einen Schlitten, der mit einer definierten Spaltbreite und Zuggeschwindigkeit gesteuert werden kann, gleichmäßig verteilt. Durch Beheizen und einen Stickstoffstrom werden die so erzeugten Filme getrocknet, so dass extrem glatte, definierte Schichten erzeugt werden können.

Zur Herstellung der dünnen Schichten wurde das in Xylol gelöste Polymer mit dem in Dichlormethan gelösten Metallkomplex in einem Vial gemischt und nach einer kurzen Zeit nach dem Zusammengeben als leicht getrübte Lösung auf ein mit Indiumzinnoxid (ITO) und PEDOT:PSS beschichtetes Substrat aufgetragen. Es wurde eine äquimolare Stöchiometrie gewählt.

Die Reaktion, Beschichtung und Trocknung wurden bei verschiedenen Temperaturen durchgeführt. Da der gesamte Prozess nach sehr kurzer Zeit beendet war, wurden die Proben anschließend für eine Stunde auf einer Heizplatte bei 100 °C getempert, um einen möglichst hohen Umsatz der Huisgen-Reaktion zu erreichen. Die Proben wurden unter einer UV-Lampe sowie per Rasterkraftmikroskopie untersucht. Außerdem wurden zur Reaktionskontrolle die Filme vor und nach dem Trocknen durch Eintauchen in Xylol gespült. Während das vernetzte Produkt unlöslich ist, lösen sich die Edukte in diesem Lösemittel, sodass durch die Beständigkeit der Schichten eine Aussage über eine erfolgreiche Quervernetzung möglich ist.

Mit zunehmender Prozesstemperatur stieg auch die Spülbeständigkeit. Nach dem Temperschritt waren alle getesteten Schichten beständig gegen Xylol. Die verschiedenen Proben wurden per AFM (Rasterkraftmikroskop) vermessen, um die Morphologie der Schichten auf nanoskaliger Ebene zu untersuchen.

Durch Rasterkraftmikroskopie konnte der durch optischen Vergleich gewonnene Eindruck, dass sich die Eigenschaften der quervernetzten Proben durch das Spülen nicht mehr verändern lässt, bestätigt werden. Zusätzlich wurde die Rauigkeit Rq(Standardabweichung der Höhenverteilungskurve) bestimmt (gemäß E. P. Degarmo, J. T. Black, R. A. Kohser, Materials and Processes in Manufacturing, 2003, 9. Auflage, Wiley, 223). Dazu wurden die gesamte Scanfläche oder bei Verunreinigungen ein Ausschnitt davon ausgewählt. Die Ergebnisse sind in der nachstehendenTabelle 1 aufgeführt.

Die Rauigkeit ist für die gemessenen Proben mit Werten zwischen 0,53 und 1,64 nm sehr niedrig, was für eine exzellente Morphologie der gemessenen Proben spricht.

**Tabelle 1: Rauigkeit der AFM-Proben. In den ersten vier Proben zeigten sich Pinholes, die Bestimmung erfolgte daher nicht über den gesamten Messbereich, sondern über einen loch-freien Bereich, um repräsentative Ergebnisse zu erhalten.**

| **Probe** | | | **Rauigkeit R_{q}** | **Bezogen auf eine Fläche von** |
|---|---|---|---|---|
| **80** | 11 °C | | 0.66 nm | 0.478 µm² |
| **80** | 11 °C | gespült | 0.99 nm | 0.397 µm² |
| **81** | 25 °C | | 0.53 nm | 0.4853 µm² |
| **81** | 25 °C | gespült | 0.70 nm | 0.495 µm² |
| **82** | 40 °C | | 1.64 nm | 1.000 µm² |
| **82** | 40 °C | gespült | 0.91 nm | 1.000 µm² |

In Figur 4 sind zum Vergleich Histogramme gezeigt. Demnach ergeben sich recht scharfe, nahezu Gauß-förmige Höhenverteilungen. Die Standardabweichung dieser Verteilungskurven ist in Tabelle als Rq angegeben.

### Beispiel 4

### Gleichzeitige einseitig Anknüpfung des Metallkomplexes

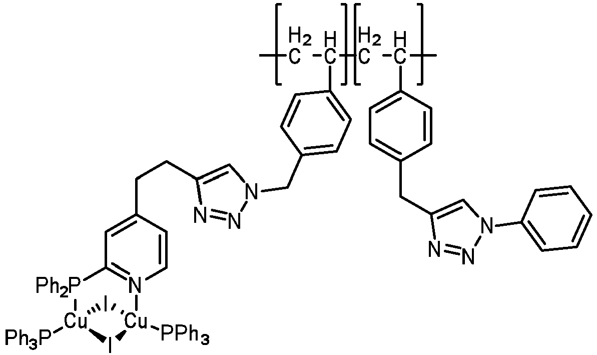

Um auf einfache, modulare Weise sowohl Kupferkomplexe (als erster Reaktand) als Emitter, als auch Ladungstransport-Einheiten (als dritter Reaktand) in ein Polymer (als zweiter Reaktand) zu bringen, wurde der Metallkomplex, ein Überschuss Azid und Phenylacetylen umgesetzt. Es wurden beide Alkine ans Polymer geknüpft. Außerdem luminesziert das Produkt wie erwartet, der Komplex bleibt also intakt.

### Beispiel 5

### Cu(I)-Katalyse mit den PyrPHOS-Komplexen

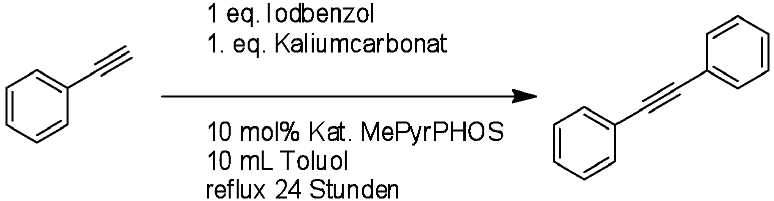

Einerseits soll das katalytische Potential der PyrPHOS-Systeme über die Cu(I)-Huisgen-Reaktion hinaus evaluiert werden. Mit den unlöslichen, quervernetzen PyrPHOS-Polymeren könnte somit ein Festphasen-Katalysator mit immobilisiertem Cu(I) vorliegen.

Andererseits können mit derartigen Reaktionen die Eigenschaften der Metallkomplexe modifiziert werden, z. B.:

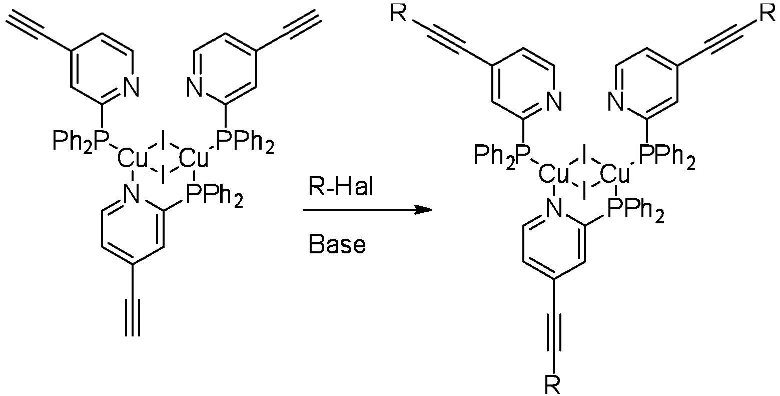

Die oben gezeigte Reaktion lief mit vollständigem Umsatz (mittels IGC-MS bestimmt) ab, außerdem konnte der in Toluol unlöslich Katalysator mit dem Kaliumcarbonat abfiltriert werden und blieb intakt (Erhalt der gelben Photolumineszenz).

### Beispiel 6

### Thiol-En-Reaktion

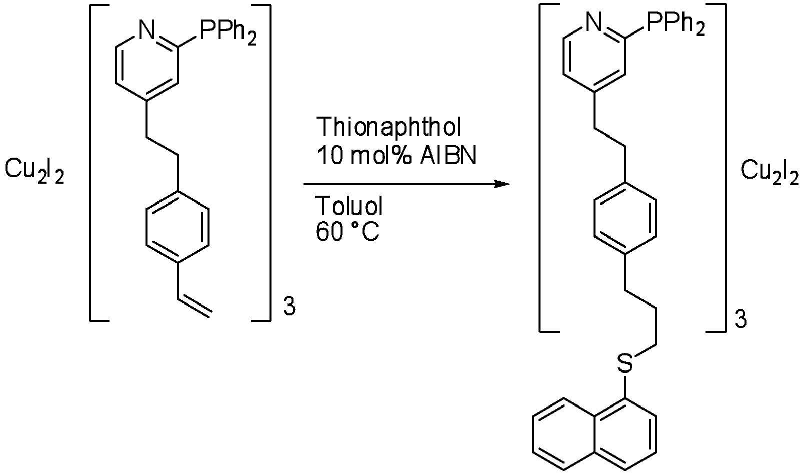

Das rechts gezeigte Produkt luminesziert wie das links gezeigte Edukt. Der typische Geruch eines freien Thiols war nach der Reaktion nicht mehr vorhanden.

### Beispiel 7: Umsetzung von heteroleptischen Komplexen mit ladungstransportierenden Gruppen

Wie hierin beschrieben können über die Anknüpfungsreaktion auch Ladungstransporteinheiten, wie sie beispielsweise für organische Leuchtdioden verwendet werden, eingebaut werden.

### Zweikernige N^P-Cul-Komplexe, die mit N-(4-Azidpphenyl)-carbazol umgesetzt wurden:

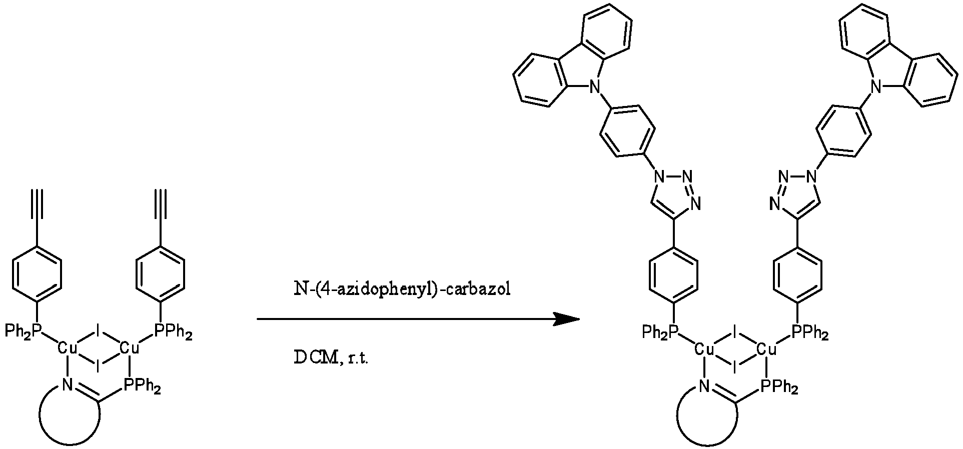

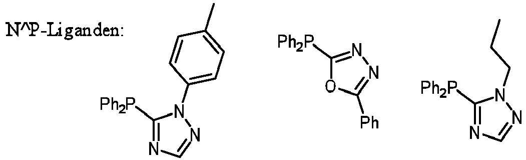

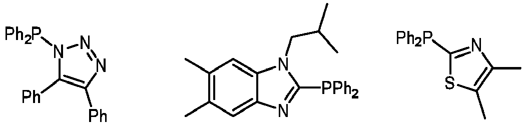

### Beispiel 8: Liganden zur Synthese von Kupferkomplexen, die eine Anbindung per Huisgen-Clickreaktion ermöglichen

### Beispiel 8.1: Syntheseroute zu Alkin-modifizerten Bisdiphenylphosphino-benzol-Derivaten

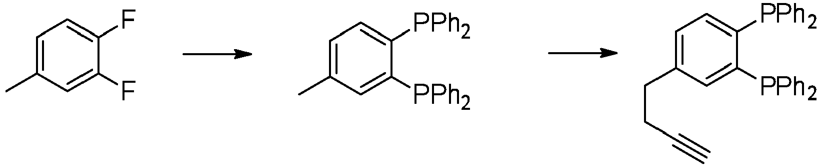

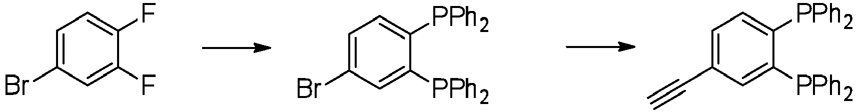

### Beispiel 8.2: Verschiedene Alkin-substituierte Liganden, die sich zur Darstellung Alkin-substituierter Kupferkomplexe eignen.

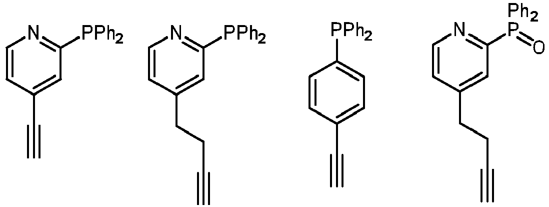

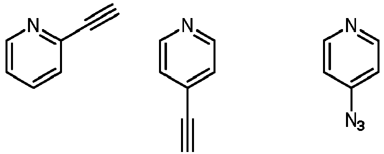

### Beispiel 9: Modifikation bereits bekannter Komplexe zur Erzielung einer Anknüpfbarkeit

Mit Hilfe der Erfindung lassen sich auch bereits bekannte Emitterkomplexe modifizieren, um eine Anknüpfbarkeit zu realisieren. Dazu werden an einen Komplexe zwei oder mehr geeignete Ankergruppen eingeführt. Hierzu eignen sich alle in Figur 2 gezeigten Ankergruppen-Paare.

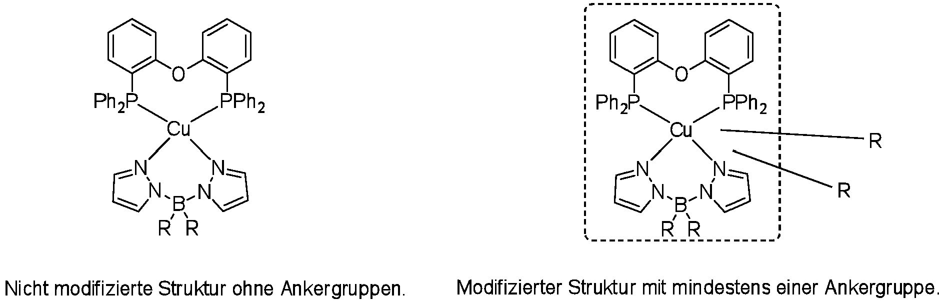

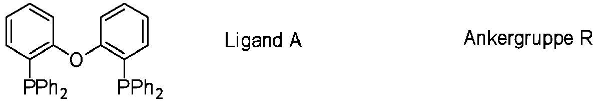

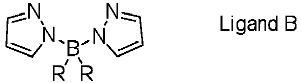

Die Grundstruktur in dieser Abbildung ist bereits bekannt (Inorg. Chem. 2011, 50, 8293). Durch Substitution mit einer oder mehr Ankergruppen wird eine neue Struktur erzeugt, die vernetzbar oder anknüpfbar ist. Dabei können alle Ankergruppen R an einem der Liganden A oder B angefügt werden oder auch die Ankergruppen auf beide Liganden verteilt werden. Die Vernetzung lässt sich über die Zahl der Ankergruppen pro Komplex beeinflussen.

### Beispiel 9.1 Modifikation bekannter Strukturen

Bereits bekannte Komplexe lassen sich durch Einfügen einer Ankergruppe so modifizieren, dass eine Vernetzung möglich ist. Verwendet werden können heteroleptische und homoleptische Komplexe.

Modifizierbare, bereits bekannte Strukturen sind in der Abbildung aufgeführt. Die Liganden, die sich für eine Modifikation nach dieser Erfindung eignen, sind mit Kästen unterlegt. Manche Liganden wie Halogenide und Pseudohalogenide eignen sich aus chemischen Gründen nicht für eine derartige Modifikation. Bei geladenen Komplexen wie dem Beispiel aus E. J. Org. Chem. aus der Abbildung sollte das lumineszierende Ion, in diesem Fall das Kation, angebunden werden.

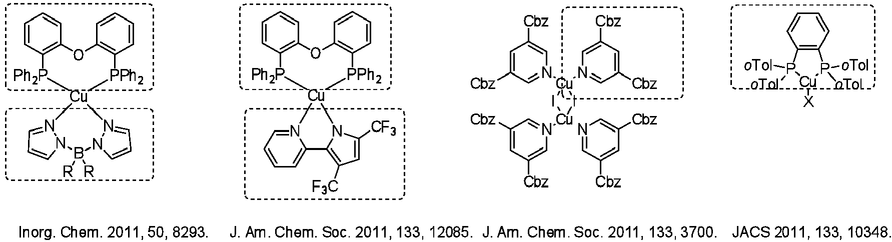

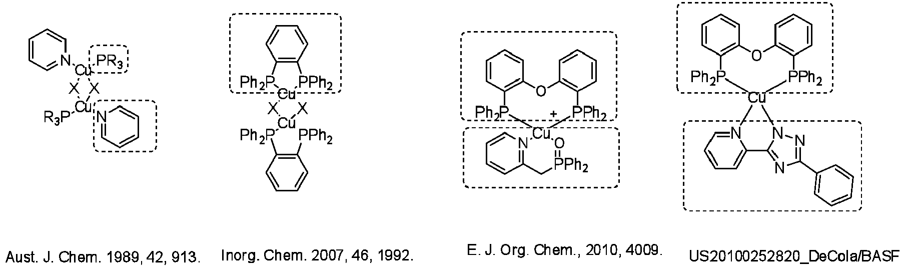

### Beispiel 9.2: Synthese und spektroskopische Eigenschaften einiger vernetzbarer Cu-Komplexe

In der nachfolgenden Abbildungen sind drei Beispiele, die sich zur Anknüpfung an ein Polymer eignen, aufgeführt.

**Synthese der Komplexe 9.2 A und 9.2 B:** Kupfer-tetrakisacetonitril-tetrafluoroborat (1 mmol, 1 Äquiv.) wurde mit den entsprechenden Neocuproin-Derivaten (1 mmol, 1 Äquiv.) und den Phosphinen (1 mmol, 1 Äquiv. für 9.2 A und 2 mmol, 2 Äquiv für 9.2 B) in einem Gläschen mit Rührfisch und Septum unter Stickstoff vorgelegt und in 10 mL trockenem Dichlormethan gelöst. Die Reaktionsmischung wurde über Nacht gerührt, das Volumen am Vakuum auf die Hälfte eingeengt und die Zielverbindung durch Eintropfen in n-Hexan ausgefällt. Die Identität der Verbindung wurde durch 1H-NMR, 31-P-NMR, Elementaranalyse und Massenspektroskopie bestätigt.

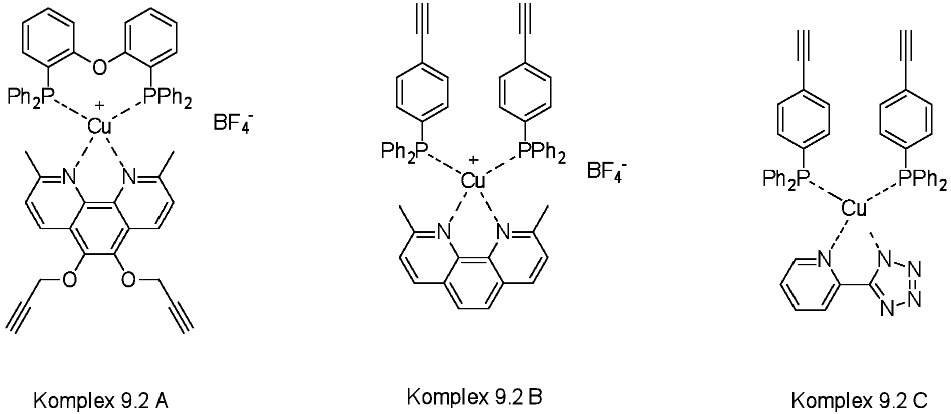

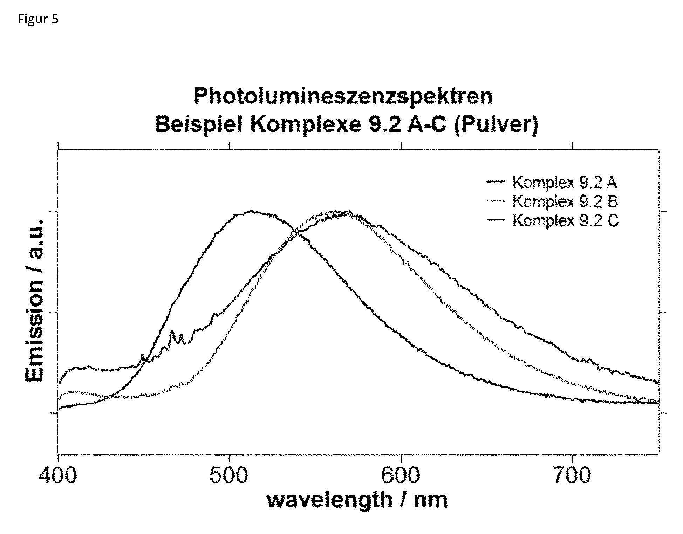

Von den Verbindungen wurden Photolumineszenzspektren aufgenommen (Pulvermessung, Raumtemperatur, unter normaler Atmosphäre): s. Figur 5.

### Beispiel 10: Anordnung der Ankergruppen

Wird eine Ankergruppe verwendet, so resultiert ein lösliches Compositmaterial. Werden zwei Ankergruppen verwendet, die räumlich hinreichend weit getrennt sind, dann wird ein vernetztes, unlösliches Polymer-Composit erhalten.

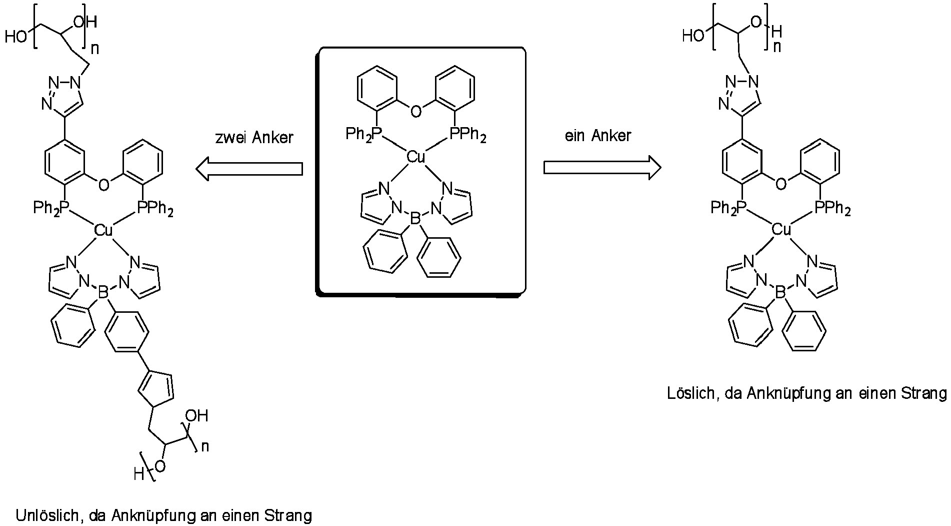

Wichtig ist für das Schalten zwischen Anknüpfung und Vernetzung ist in diesem Zusammenhang auch die Positionierung der Ankergruppen: Wenn zwei Ankergruppen sehr dicht beieinander, auf derselben Seite eines Moleküls angebracht werden, wirkt der Komplex nicht vernetzend, da dann aus geometrischen Gründen bevorzugt eine Anknüpfung an einen Polymerstrang stattfindet.

Dies zeigte sich für den Beispiel Komplex 10 A:

### Clickanbindung von Beispiel-Komplex 10 A

Komplex 10 A (1 Äquvi., 0.1 mmol) wurde unter Stickstoff in einem 10 mL Vial mit Dichlormethan gelöst. Glycidyl-azid-polymer "GAP" (2 Monomer-äquivalente, 0.2 mmol) wurde in 0.5 mL Dichlormethan gelöst und zur Komplexlösung gegeben. Die Reaktionsmischung wurde über Nacht gerührt, auf 1/3 des ursrpünglichen Volumens eingeengt und durch Eintropfen in Hexan ausgefällt.

Die Identität des Beispiel Click-Komplexes 10 A-GAP wurde durch 1H NMR, Infrarot-Spektroskopie und Elementaranalyse bestätigt.

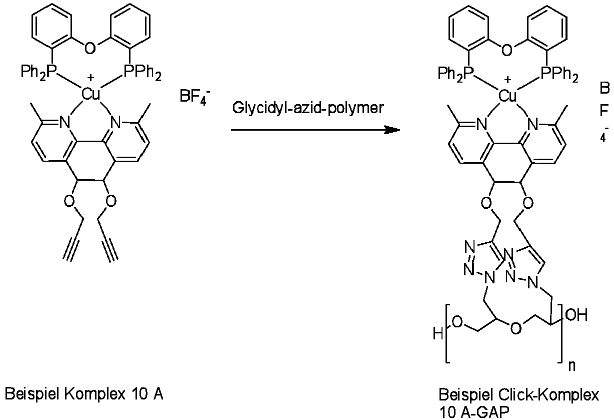

Alle in der nachfolgenden Abbildung aufgeführten Metallkomplexe geben bei Umsetzung mit dem Ankergruppen-funktionalisierten Glycidyl-azid-Polymer lösliche Composit-Materialien, die nur über eine Seite des Metallkomplexes angeknüpft wurden.

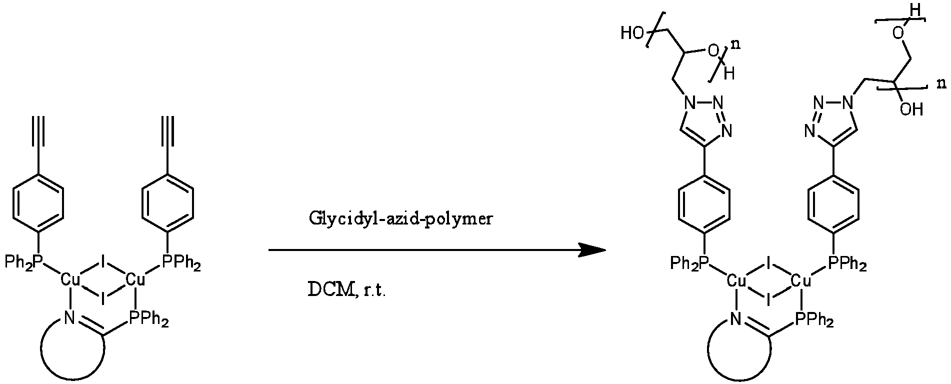

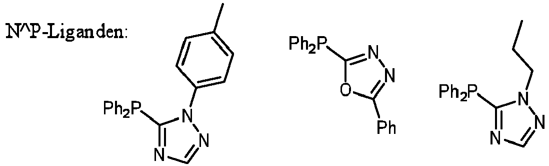

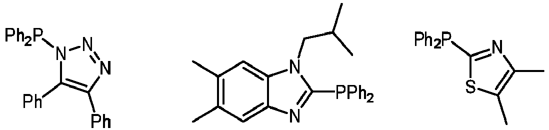

### Beispiel 11: Anknüpfung von Komplexen, die nur eine Ankergruppe tragen

Werden gezielt Komplexe eingesetzt, die nur über eine einzige Ankergruppe verfügen, so werden potentiell lösliche, Komplex-haltige Polymere erhalten. Diese sind nicht quervernetzt, weisen aber aufgrund des polymeren Rückgrats eine stark verminderte Diffusionstendenz auf und ermöglichen auf diese Weise die Immobilisierung von Metallkomplexen, etwa für die Katalyse oder für optoelektronische Anwendungen in OLEDs. 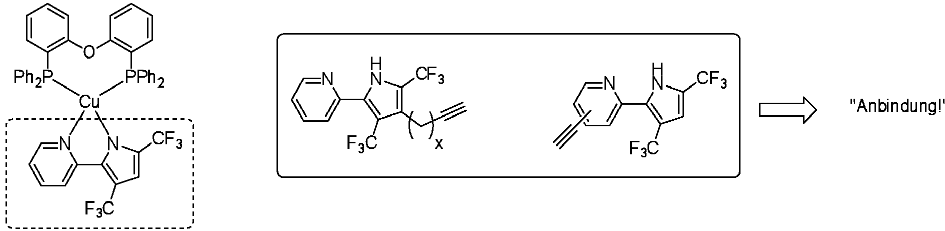 **Synthese der Komplexe 11 A und 11 B:** Kupfer-tetrakisacetonitril-tetrafluoroborat (Beispiel Komplex 11 A 1 mmol, 1 Äquiv.) beziehungsweise -hexafluorophosphat (Beispiel Komplex 11 B, 1 mmol, 1 Äquiv.) wurde mit dem Bisphosphinliganden POP (1 Äquiv., 1 mmol) und dem Ankergruppen-funktionalisierten Liganden 4-But-4'-in-2-diphenylphosphinoxido-pyridin (1 Äquiv, 1 mmol) in einem Gläschen mit Septum und Rührfisch unter Stickstoff vorgelegt. 10 mL trockenes Dichlormethan wurden zugegeben und die Reaktionsmischung für 2 Stunden bei Raumtemperatur gerührt. Das Volumen am Vakuum auf die Hälfte eingeengt und die Zielverbindung durch Eintropfen in n-Hexan ausgefällt. Die Identität der Verbindung wurde durch 1H-NMR, 31-P-NMR, Elementaranalyse und Infrarotspektroskopie bestätigt.

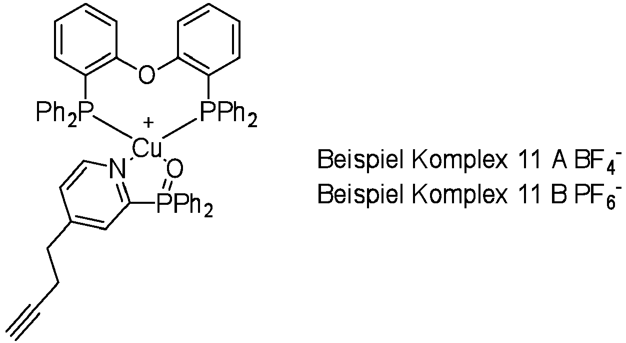

### Beispiel 12: Anwendung des Konzeptes auf andere Metallkomplexe

Das Konzept lässt sich auch auf andere Metalle als Kupfer anwenden. Dabei müssen ggf. einige der Ankergruppen den chemischen Eigenschaften der anzuknüpfenden Metallkomplexe angepasst werden. In den folgenden Beispielen werden für einige ausgewählte Metalle derartige Möglichkeiten aufgezeigt.

**Beispiel 12.1: Gold-Komplexe**

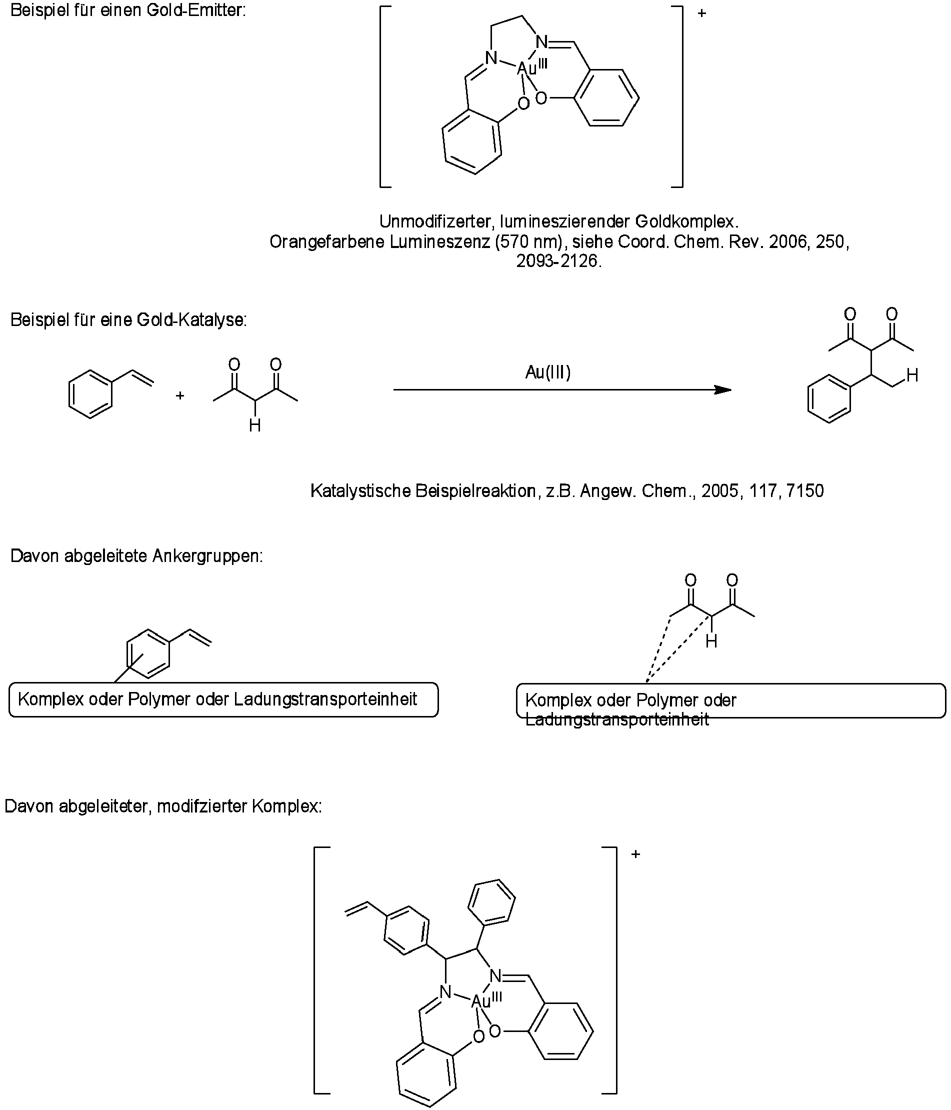

### Beispiel 12.2: Ruthenium-Komplexe

Rutheniumkomplexe katalysieren ebenfalls Cycloadditionen zwischen Alkinen und Aziden, ergeben aber im Gegensatz zu den Kupfer-katalysierten Click-Reaktionen nicht 1,4- sondern 1,5-Triazole.

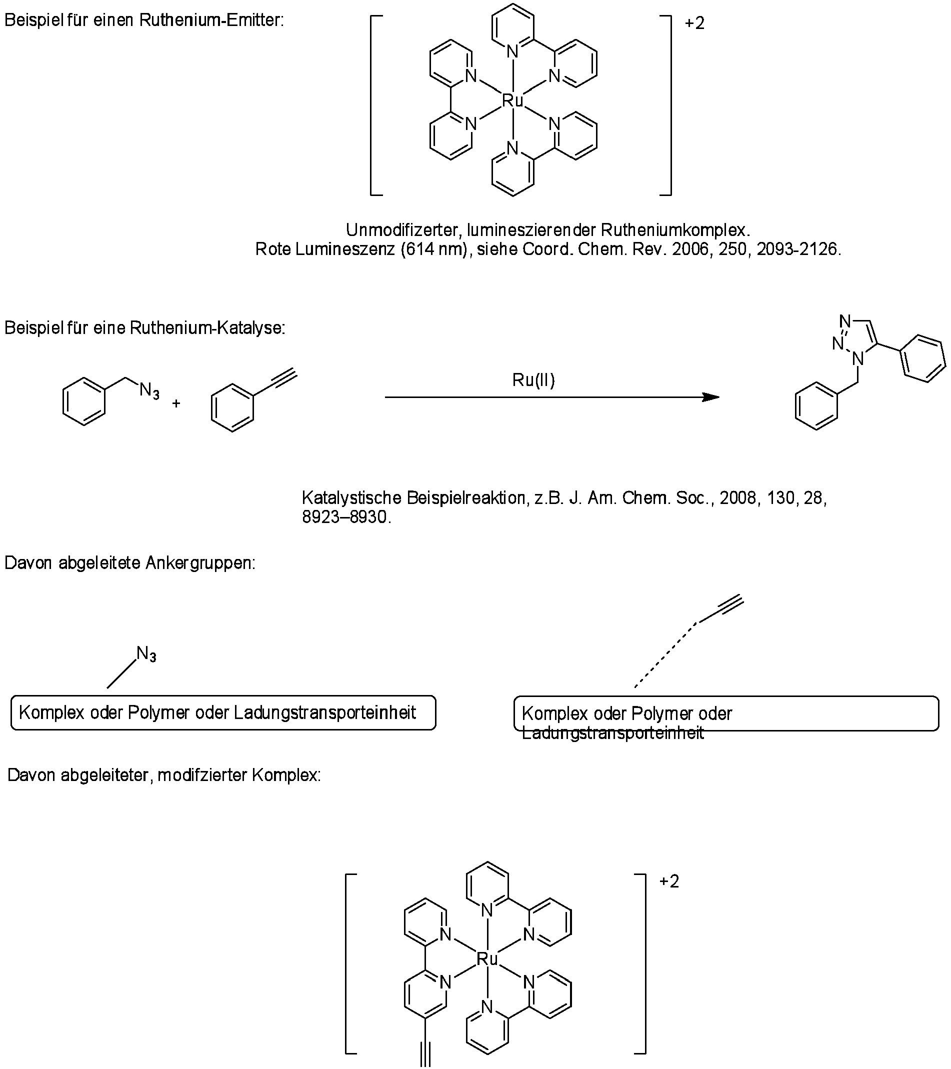

### Beispiel 12.3: Zink-Komplexe

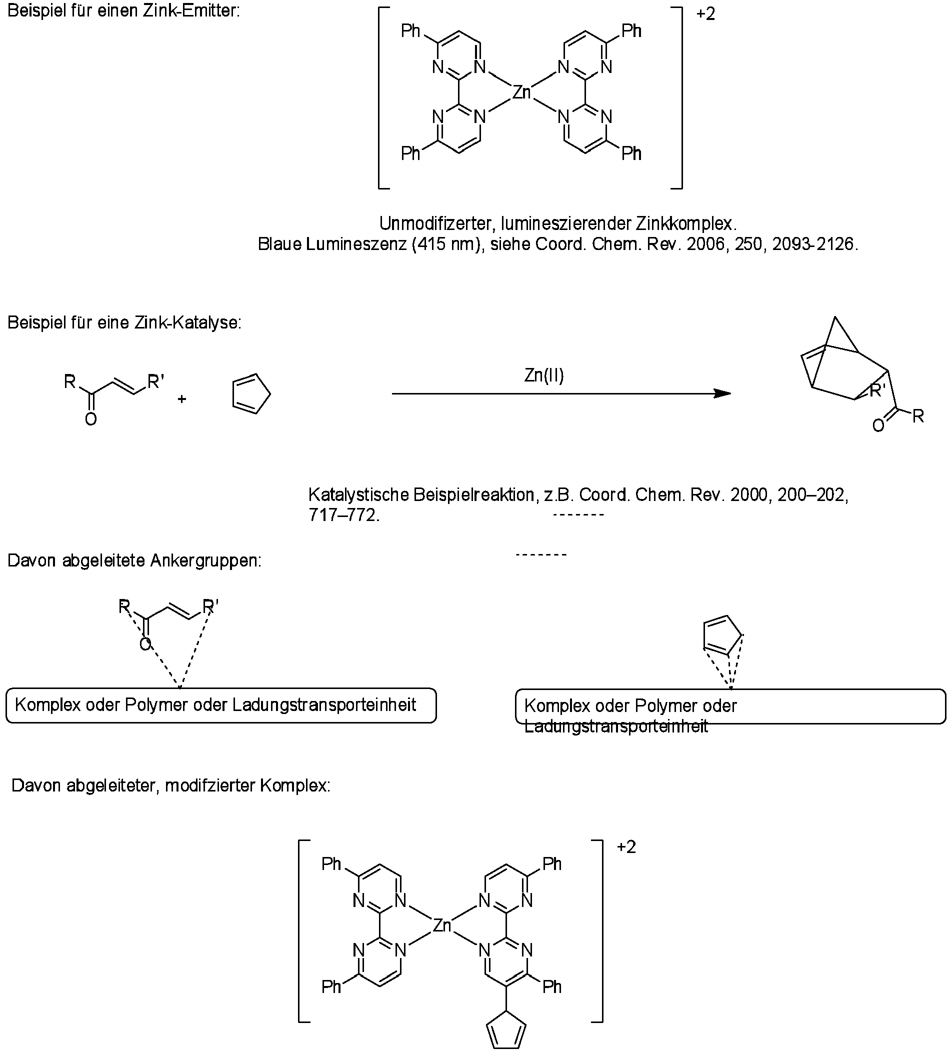

### Beispiel 12.4: Platin-Komplexe

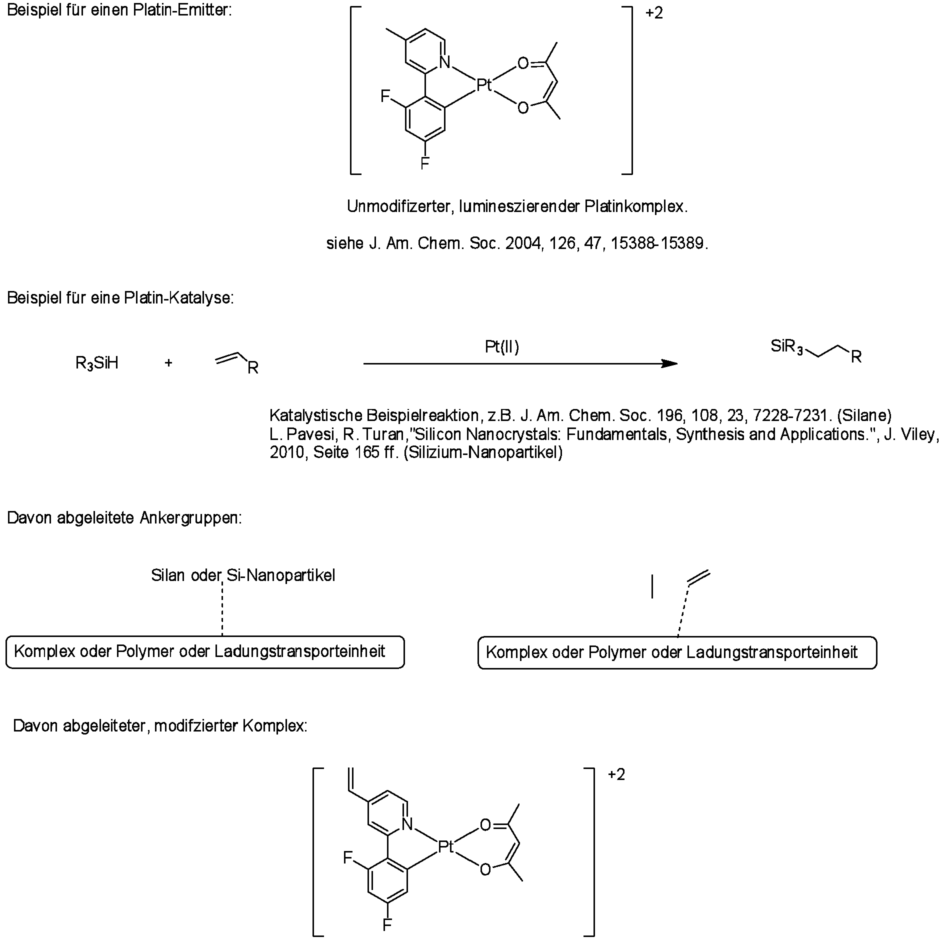

### Beispiel 11

Querverknüpfung eines Cu(I)-Komplexes über ein Spacer-Molekül (dritter Reaktand) mit einem Polymer

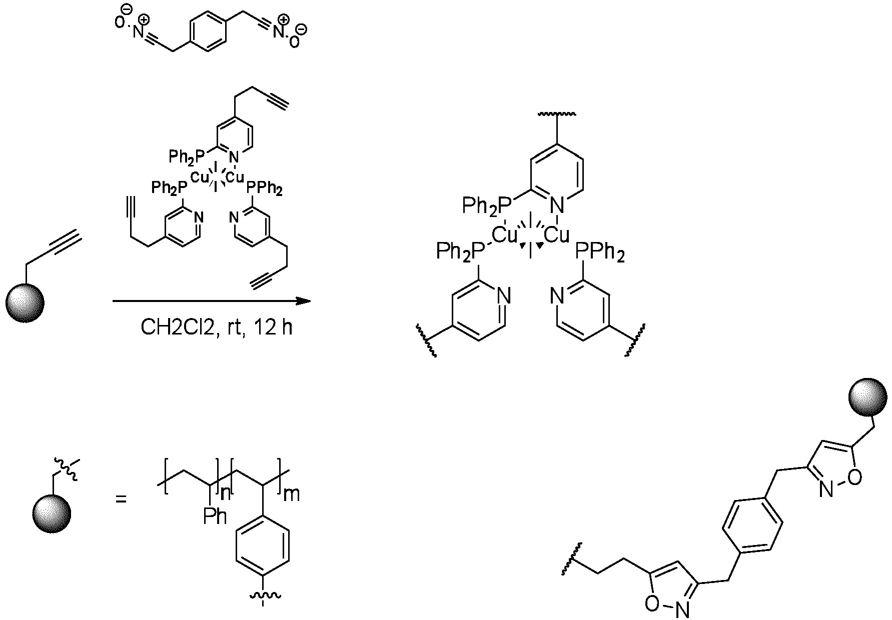

## Patentansprüche

1. Verfahren zur kovalenten Bindung eines organischen Metallkomplexes mit mindestens einem Metallzentrum und mindestens einem organischen Liganden an ein Polymer,
umfassend das Durchführen einer ersten Reaktion, die aufweist
- einen ersten Reaktanden in Form eines organischen Metallkomplexes und
- einen zweiten Reaktanden in Form eines Polymers,
wobei während der Reaktion der Metallkomplex kovalent an das Polymer gebunden wird,
**dadurch gekennzeichnet, dass**
die Reaktion durch das Metallzentrum des Metallkomplexes katalysiert wird.

2. Verfahren nach Anspruch 1, wobei das Metallzentrum des Metallkomplexes ausgewählt ist aus der Gruppe bestehend aus Re, Fe, Ru, Os, Co, Rh, Ir, Ni, Pd, Pt, Cu, Ag, Au, Zn, Cd, Hg, Sn und Pb.

3. Verfahren nach Anspruch 1 oder 2, wobei
- der Metallkomplex eine Ankergruppe einer ersten Ankergruppenspezies zur kovalenten Bindung des Metallkomplexes an das Polymer aufweist und
- der zweite Reaktand eine Ankergruppe einer zweiten Ankergruppenspezies zur kovalenten Bindung an den Metallkomplex aufweist, und wobei
die kovalente Bindung des Metallkomplexes an das Polymer durch Reaktion der Ankergruppe des Metallkomplexes mit der Ankergruppe des zweiten Reaktanden erfolgt.

4. Verfahren nach Anspruch 1 oder 2, wobei
- der Metallkomplex eine Ankergruppe einer ersten Ankergruppenspezies zur kovalenten Bindung des Metallkomplexes an das Polymer mittels einer Ankergruppe einer zweiten Ankergruppenspezies aufweist und
- der zweite Reaktand eine erste Ankergruppe einer ersten Ankergruppenspezies zur kovalenten Bindung des zweiten Reaktanden an eine Ankergruppe einer zweiten Ankergruppenspezies aufweist, und wobei
die kovalente Einbindung des Metallkomplexes an das Polymer durch Reaktion der Ankergruppe des Metallkomplexes mit einem dritten Reaktanden erfolgt, der zwei Ankergruppen einer zweiten Ankergruppenspezies aufweist.

5. Verfahren nach Anspruch 4, wobei das Reaktionsprodukt ein mehrdimensionales Netzwerk mit querverknüpften organischen Metallkomplexen darstellt, das unlöslich ist.

6. Verfahren nach Anspruch 1 bis 5, wobei die erste und zweite Ankergruppenspezies ausgewählt sind aus folgenden korrespondierenden Paaren von ersten und zweiten Ankergruppenspezies 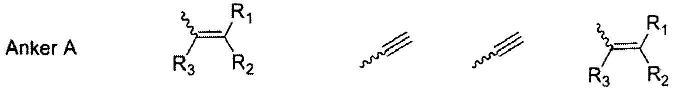 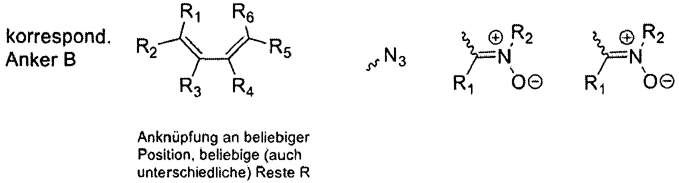 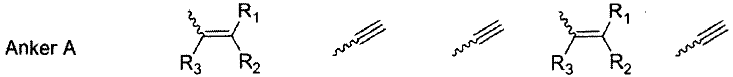 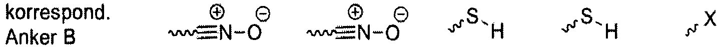 wobei
R1-R6 können jeweils unabhängig voneinander Wasserstoff, Halogen sein oder Substituenten, die über Sauerstoff- (-OR*), Stickstoff- (-NR*₂) oder Siliziumatome (-SiR*₃) gebunden sind sowie Alkyl-(auch verzweigt oder zyklisch), Aryl-, Heteroaryl-, Alkenyl-, Alkinyl-Gruppen oder substituierte Alkyl-(auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere Donor- und Akzeptor-Gruppen wie Amine, Carbonyle, Carboxylate und deren Ester, und CF₃-Gruppen; R1-R6 führen optional zu annelierten Ringsystemen;
R* = organischer Rest, der ausgewählt ist aus der Gruppe bestehend aus: Wasserstoff, Halogen oder Deuterium, sowie Alkyl- (auch verzweigt oder zyklisch), Aryl-, Heteroaryl-, Alkenyl-, Alkinyl-Gruppen oder substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere Donor- und Akzeptor-Gruppen wie Amine, Carboxylate und deren Ester, und CF₃-Gruppen;
X = Halogen, OSO₂Me, OSO₂Tolyl oder OSO₂CF₃.

7. Verfahren nach Anspruch 1 bis 6, wobei ein vierter Reaktand zum Transport oder zur Blockierung elektrischer Ladungen an der Reaktion teilnimmt, der eine Ankergruppe der ersten oder zweiten Ankergruppenspezies aufweist.

8. Verfahren nach Anspruch 1 bis 7, wobei neben dem ersten Reaktanden, dem zweiten Reaktanden, optional dem dritten Reaktanden und optional dem vierten Reaktanden kein weiterer Reaktand an der Reaktion teilnimmt.

## Claims

1. A Method for covalently binding an organic metal complex with at least one metal center and at least one organic ligand to a polymer, comprising
performing a first reaction, which comprises
- a first reactant in the form of an organic metal complex and
- a second reactant in the form of a polymer,
wherein the metal complex is covalently bound to the polymer during the reaction,
**characterized in that**
the reaction is catalyzed by the metal center of the metal complex.

2. The method according to claim 1, wherein the metal center of the metal complex is selected from the group consisting of Re, Fe, Ru, Os, Co, Rh, Ir, Ni, Pd, Pt, Cu, Ag, Au, Zn, Cd, Hg, Sn and Pb.

3. The method according to claim 1 or 2, wherein
- the metal complex comprises an anchor group of a first anchor group species for covalently binding the metal complex to the polymer and
- the second reactant comprises an anchor group of a second anchor group species for covalently binding to the metal complex, and wherein
the covalent binding of the metal complex to the polymer is achieved through the reaction of the anchor group of the metal complex with the anchor group of the second reactant.

4. The method according to claim 1 or 2, wherein
- the metal complex comprises an anchor group of a first anchor group species for covalently binding the metal complex to the polymer via an anchor group of a second anchor group species, and
- the second reactant comprises a first anchor group of a first anchor group species for covalently binding the second reactant to an anchor group of a second anchor group species, and wherein
the covalent binding of the metal complex to the polymer is achieved through the reaction of the anchor group of the metal complex with a third reactant which comprises two anchor groups of a second anchor group species.

5. The method according to claim 4, wherein the reaction product is an insoluble multidimensional network with cross-linked organic metal complexes.

6. The method according to claims 1 to 5, wherein the first and the second anchor group species are selected from the following corresponding pairs of first and second anchor group species 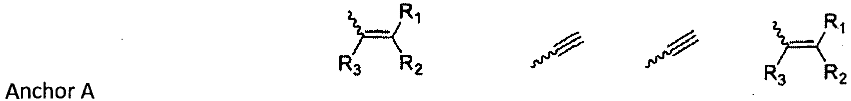 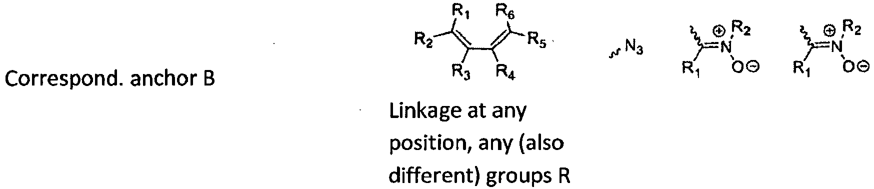 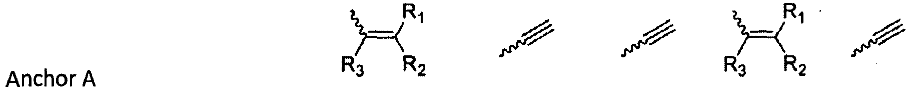 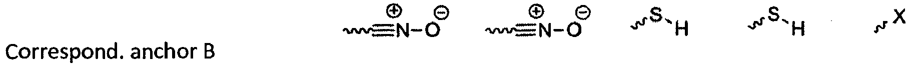 wherein
R1-R6 can each independently be hydrogen, halogen or substituents, which are bound via oxygen (-OR*), nitrogen (-NR*₂) or silicon atoms (-SiR*₃) as well as alkyl (also branched or cyclic), aryl, heteroaryl, alkenyl, alkynyl groups or substituted alkyl (also branched or cyclic), aryl, heteroaryl and alkenyl groups with substituents such as halogens or deuterium, alkyl groups (also branched or cyclic), and further generally known donor and acceptor groups such as amines, carbonyls, carboxylates and their esters, and CF₃ groups; R1-R6 optionally lead to annulated ring systems;
R* = organic group, selected: hydrogen, halogen or deuterium, as well as alkyl (also branched or cyclic), aryl, heteroaryl, alkenyl, alkynyl groups or substituted alkyl (also branched or cyclic), aryl, heteroaryl and alkenyl groups with substituents such as halogens or deuterium, alkyl groups (also branched or cyclic), and further generally known donor and acceptor groups such as amines, carboxylates and their esters, and CF₃ groups;
X = halogen, OSO₂Me, OSO₂TolyL, or OSO₂CF₃.

7. The method according to claims 1 to 6, wherein a fourth reactant for the transport or blockage of electric charges takes part in the reaction, which comprises an anchor group of the first or second anchor group species.

8. The method according to claims 1 to 7, wherein no further reactant takes part in the reaction besides the first reactant, the second reactant, optionally the third reactant and optionally the fourth reactant.

## Revendications

1. Procédé pour la liaison covalente d'un complexe métallique organique, présentant au moins un centre métallique et au moins un ligand organique, à un polymère, comprenant la réalisation d'une première réaction qui présente
- un premier réactif sous forme d'un complexe métallique organique et
- un deuxième réactif sous forme d'un polymère,
le complexe métallique étant lié par covalence au polymère pendant la réaction, **caractérisé en ce que** la réaction est catalysée par le centre métallique du complexe métallique.

2. Procédé selon la revendication 1, le centre métallique du complexe métallique étant choisi dans le groupe constitué par Re, Fe, Ru, Os, Co, Rh, Ir, Ni, Pd, Pt, Cu, Ag, Au, Zn, Cd, Hg, Sn et Pb.

3. Procédé selon la revendication 1 ou 2,
- le complexe métallique présentant un groupe d'ancrage d'une première espèce de groupes d'ancrage pour la liaison covalente du complexe métallique au polymère et
- le deuxième réactif présentant un groupe d'ancrage d'une deuxième espèce de groupes d'ancrage pour la liaison covalente au complexe métallique et
la liaison covalente du complexe métallique au polymère ayant lieu par réaction du groupe d'ancrage du complexe métallique avec le groupe d'ancrage du deuxième réactif.

4. Procédé selon la revendication 1 ou 2,
- le complexe métallique présentant un groupe d'ancrage d'une première espèce de groupes d'ancrage pour la liaison covalente du complexe métallique au polymère au moyen d'un groupe d'ancrage d'une deuxième espèce de groupes d'ancrage et
- le deuxième réactif présentant un premier groupe d'ancrage d'une première espèce de groupes d'ancrage pour la liaison covalente du deuxième réactif à un groupe d'ancrage d'une deuxième espèce de groupes d'ancrage et
la liaison covalente du complexe métallique au polymère ayant lieu par réaction du groupe d'ancrage du complexe métallique avec un troisième réactif, qui présente deux groupes d'ancrage d'une deuxième espèce de groupes d'ancrage.

5. Procédé selon la revendication 4, le produit de réaction représentant un réseau multidimensionnel doté de complexes métalliques organiques réticulés, qui est insoluble.

6. Procédé selon la revendication 1 à 5, la première et la deuxième espèce de groupes d'ancrage étant choisies parmi les paires correspondantes suivantes de première et de deuxième espèce de groupes d'ancrage 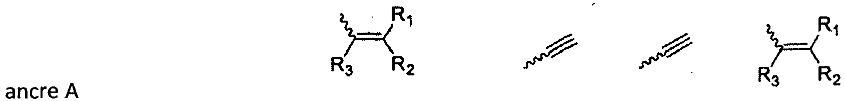 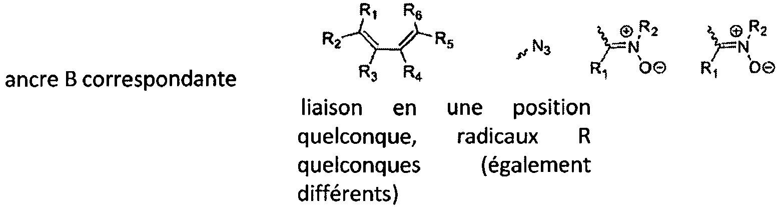 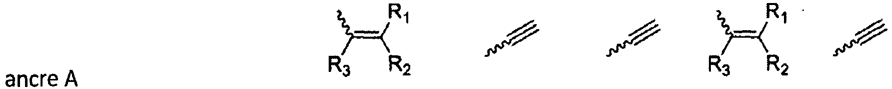 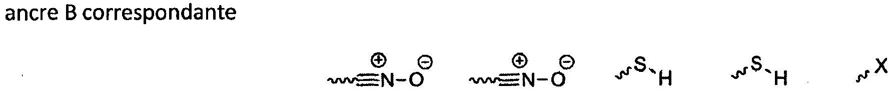 dans lesquelles
R1-R6 peuvent représenter, à chaque fois indépendamment les uns des autres, hydrogène, halogène ou des substituants, qui sont liés via des atomes d'oxygène (-OR*), des atomes d'azote (-NR*₂) ou des atomes de silicium (-SiR*₃), ainsi que des groupes alkyle (également ramifiés ou cycliques), aryle, hétéroaryle, alcényle et alcynyle ; ou des groupes alkyle (également ramifiés ou cycliques), aryle, hétéroaryle et alcényle substitués présentant des substituants tels que des halogènes ou du deutérium, des groupes alkyle (également ramifiés ou cycliques) ; et d'autres groupes donneurs et accepteurs, tels que des amines, des carbonyles, des carboxylates et leurs esters ; et des groupes CF₃ ; R₁-R₆ conduisent éventuellement à des systèmes cycliques annelés ;
R* = un radical organique qui est choisi dans le groupe constitué par : hydrogène, halogène ou deutérium ainsi que des groupes alkyle (également ramifiés ou cycliques), aryle, hétéroaryle, alcényle, alcynyle ou des groupes alkyle (également ramifiés ou cycliques), aryle, hétéroaryle et alcényle substitués, présentant des substituants tels que des halogènes ou du deutérium, des groupes alkyle (également ramifiés ou cycliques) ; et d'autres groupes donneurs et accepteurs, tels que des amines, des carboxylates et leurs esters ; et des groupes CF₃ ;
X = halogène, OSO₂Me, OSO₂toluyle ou OSO₂CF₃.

7. Procédé selon la revendication 1 à 6, un quatrième réactif participant à la réaction pour le transport ou pour le blocage de charges électriques, qui présente un groupe d'ancrage de la première ou de la deuxième espèce de groupes d'ancrage.

8. Procédé selon la revendication 1 à 7, aucun autre réactif, outre le premier réactif, le deuxième réactif, éventuellement le troisième réactif et éventuellement le quatrième réactif, ne participant à la réaction.
